(19) Europäisches Patentamt
European Patent Office
Office européen des brevets

(11) **EP 4 750 283 A1**

(12) **EUROPEAN PATENT APPLICATION**
published in accordance with Art. 153(4) EPC

(43) Date of publication:
**27.05.2026 Bulletin 2026/22**

(21) Application number: **24843146.2**

(22) Date of filing: **17.07.2024**

(51) International Patent Classification (IPC):
**H10K 39/10** $^{(2026.01)}$     **H10K 30/40** $^{(2023.01)}$

(52) Cooperative Patent Classification (CPC):
**H10K 30/40; H10K 39/10;** Y02B 10/10

(86) International application number:
**PCT/JP2024/025581**

(87) International publication number:
**WO 2025/018357 (23.01.2025 Gazette 2025/04)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **19.07.2023 JP 2023117841**

(71) Applicant: **Panasonic Intellectual Property Management Co., Ltd.**
**Kadoma-shi, Osaka 571-0057 (JP)**

(72) Inventors:
• **HIGUCHI, Hiroshi**
**Kadoma-shi, Osaka 571-0057 (JP)**
• **HIRANO, Koichi**
**Kadoma-shi, Osaka 571-0057 (JP)**
• **KATAYAMA, Hirotaka**
**Kadoma-shi, Osaka 571-0057 (JP)**

(74) Representative: **Appelt, Christian W.**
**Boehmert & Boehmert**
**Anwaltspartnerschaft mbB**
**Pettenkoferstrasse 22**
**80336 München (DE)**

(54) **POWER GENERATION MODULE AND METHOD FOR PRODUCING POWER GENERATION MODULE**

(57)     A power generation module applicable to building-integrated photovoltaics is provided. A method for manufacturing a power generation module of the present disclosure comprises: arranging a solar cell submodule (100) on a first surface of a first substrate (11) having light-transmitting properties; arranging a non-power-generating member (60b) electrically isolated from the solar cell submodule (100) in a second region (14) of the first surface, the second region (14) lying outside a first region (13) in which the solar cell submodule (100) is arranged; placing a filler (32) above the solar cell submodule (100) and the non-power-generating member (60b), the filler being in contact with at least a portion of an upper surface of the non-power-generating member (60b); and disposing a second substrate (12) having light-transmitting properties on the filler so as to face the first substrate, and bonding together the first substrate (11) and the second substrate (12) with the solar cell submodule (100) and the non-power-generating member (60b) between the first and second substrates.

Fig. 31

**Description**

TECHNICAL FIELD

The present disclosure relates to a power generation module, particularly, a photovoltaic module that can be integrated with building materials.

BACKGROUND ART

Building-integrated photovoltaics (BIPV), which are integrated with building materials such as roofs, exterior walls, and windows of buildings, are attracting attention. For example, Patent Document 1 proposes a building material with a solar cell that can be used as a window.

PRIOR ART DOCUMENT

PATENT DOCUMENT

Patent Document 1: JP2020-84640A

SUMMARY OF INVENTION

TECHNICAL PROBLEM

There are a wide variety of requirements for building-integrated photovoltaics. For example, power generation modules applied to building-integrated photovoltaics may be required to have high design quality in addition to high power generation performance. They may also be required to be compatible with a variety of building materials with different functions, shapes, sizes, etc. However, with the structure of Patent Document 1, it may be difficult to design ones that meet these requirements.

An object of the present disclosure is to solve the above problem and to provide a power generation module that is applicable to building-integrated photovoltaics.

MEANS FOR SOLVING PROBLEM

A method for manufacturing a power generation module of the present disclosure includes:

arranging a solar cell submodule on a first surface of a first substrate having light-transmitting properties;
arranging a non-power-generating member electrically isolated from the solar cell submodule in a second region of the first surface, the second region lying outside a first region in which the solar cell submodule is arranged;
placing a filler above the solar cell submodule and the non-power-generating member, the filler being in contact with at least a portion of an upper surface of the non-power-generating member; and
disposing a second substrate having light-transmitting properties on the filler so as to face the first substrate, and bonding together the first substrate and the second substrate with the solar cell submodule and the non-power-generating member between the first and second substrates.

A power generation module of the present disclosure includes:

a first substrate having light-transmitting properties;
a second substrate having light-transmitting properties and facing the first substrate in a first direction;
a solar cell submodule located between the first substrate and the second substrate;
a non-power-generating member located between the first substrate and the second substrate, the non-power-generating member being electrically isolated from the solar cell submodule; and
a filler located between the solar cell submodule and the second substrate, and between the non-power-generating member and the second substrate,
wherein, in plan view seen along the first direction, the non-power-generating member is adjacent to the solar cell submodule, at least a portion of an upper surface of the non-power-generating member being in contact with the filler.

ADVANTAGEOUS EFFECT OF INVENTION

According to the present disclosure, a power generation module applicable to building-integrated photovoltaics can be provided.

BRIEF DESCRIPTION OF DRAWINGS

Fig. 1 is a schematic top view of a power generation module according to a first embodiment of the present disclosure.
Fig. 2 is a schematic cross-sectional view of the power generation module of Fig. 1 taken along line II-II.
Fig. 3 is a schematic exploded perspective view of the power generation module of Fig. 1.
Fig. 4 is a schematic top view of one submodule in the power generation module of Fig. 1.
Fig. 5 is an enlarged top view of a portion of the submodule of Fig. 4.
Fig. 6A is an enlarged cross-sectional view taken along line VIA-VIA in Fig. 5.
Fig. 6B is an enlarged cross-sectional view taken along line VIB-VIB in Fig. 5.
Fig. 7 is an enlarged top view showing a portion of the power generation module of Fig. 1.
Fig. 8 is a schematic top view showing another example of the power generation module according to the first embodiment.
Fig. 9A is a schematic process perspective view showing a film formation step in a method for manufacturing a submodule.
Fig. 9B is a schematic process perspective view showing a film formation step in the method for manufacturing the submodule.
Fig. 9C is a schematic process perspective view showing a film processing step in the method for manufacturing the submodule.
Fig. 9D is a schematic process cross-sectional view showing a film processing step in the method for manufacturing the submodule.
Fig. 9E is a schematic process perspective view showing a film processing step in the method for manufacturing the submodule.
Fig. 9F is a schematic process cross-sectional view showing a film processing step in the method for manufacturing the submodule.
Fig. 10A is a schematic process cross-sectional view showing a film processing step in the method for manufacturing the submodule.
Fig. 10B is a schematic process cross-sectional view showing a film processing step in the method for manufacturing the submodule.
Fig. 10C is a schematic process cross-sectional view showing a film processing step in the method for manufacturing the submodule.
Fig. 11 is a schematic top view showing a wiring formation step in the method for manufacturing the submodule.
Fig. 12A is a schematic process top view showing a submodule arrangement step in the method for manufacturing the power generation module of Fig. 1.
Fig. 12B is a schematic process top view showing a submodule arrangement step in the method for manufacturing the power generation module of Fig. 1.
Fig. 13A is a schematic process cross-sectional view showing a sealing step in the method for manufacturing the power generation module of Fig. 1.
Fig. 13B is a schematic process cross-sectional view showing a sealing step in the method for manufacturing the power generation module of Fig. 1.
Fig. 13C is a schematic process cross-sectional view showing a sealing step in the method for manufacturing the power generation module of Fig. 1.
Fig. 14 is a schematic diagram illustrating the relationship between the photovoltaic film removal area ratio and the power generator area ratio of the submodule and the light transmittance.
Fig. 15 is a flowchart illustrating a method for setting the light transmittance of the submodule.
Fig. 16 is a schematic enlarged top view showing an example of a string structure.
Fig. 17 is a schematic enlarged top view showing another example of the string structure.
Fig. 18 is a schematic enlarged top view showing yet another example of the string structure.
Fig. 19A is an enlarged top view showing another example of the submodule.
Fig. 19B is an enlarged top view showing another example of the submodule.
Fig. 20 is an enlarged top view showing one submodule in a second embodiment of the present disclosure.
Fig. 21 is a schematic enlarged top view showing an example of the string structure.

Fig. 22 is a schematic enlarged top view showing another example of the string structure.

Fig. 23 is a schematic enlarged top view showing yet another example of the string structure.

Fig. 24 is an enlarged top view of one submodule for explaining a design example of varying the string width and the inter-string region width.

Fig. 25 is a schematic top view showing an example of gradation of a module column.

Fig. 26 is a schematic top view showing another example of gradation of the module column.

Fig. 27 is a schematic diagram for explaining the relationship between the distance along the Y direction from the upper end of a first submodule and the string area ratio and light transmittance in the power generation modules of the first and second embodiments.

Fig. 28A is a schematic process cross-sectional view showing a film processing step in a method for manufacturing a submodule having gradation.

Fig. 28B is a schematic process cross-sectional view showing a film processing step in the method for manufacturing the submodule having gradation.

Fig. 28C is a schematic process cross-sectional view showing a film processing step in the method for manufacturing the submodule having gradation.

Fig. 29A is a schematic process cross-sectional view showing another film processing step in the method for manufacturing the submodule having gradation.

Fig. 29B is a schematic process cross-sectional view showing another film formation step in the method for manufacturing the submodule having gradation.

Fig. 29C is a schematic process cross-sectional view showing another film processing step in the method for manufacturing the submodule having gradation.

Fig. 30 is a schematic top view showing a power generation module according to a third embodiment of the present disclosure.

Fig. 31 is a schematic cross-sectional view of the power generation module of Fig. 30 taken along line IIIXI-IIIXI.

Fig. 32A is an enlarged top view showing a submodule and a non-power-generating member in the power generation module of Fig. 30.

Fig. 32B is an enlarged top view showing another example of the submodule and non-power-generating member of the power generation module of Fig. 30.

Fig. 33 is an enlarged top view showing still another example of the submodule and non-power-generating member of the power generation module of Fig. 30.

Fig. 34 is a top view showing another example of the power generation module according to the third embodiment.

Fig. 35A is a schematic process cross-sectional view illustrating a method for manufacturing the power generation module of Fig. 30.

Fig. 35B is a schematic process cross-sectional view illustrating the method for manufacturing the power generation module of Fig. 30.

Fig. 35C is schematic process cross-sectional view illustrating the method for manufacturing the power generation module of Fig. 30.

Fig. 35D is a schematic process cross-sectional view illustrating the method for manufacturing the power generation module of Fig. 30.

Fig. 36A is a schematic process cross-sectional view illustrating a further method for manufacturing the power generation module of Fig. 30.

Fig. 36B is a schematic process cross-sectional view illustrating the further manufacturing method for the power generation module of Fig. 30.

Fig. 36C is a schematic process cross-sectional view illustrating the further method for manufacturing the power generation module of Fig. 30.

Fig. 36D is a schematic process cross-sectional view illustrating the further method for manufacturing the power generation module of Fig. 30.

DESCRIPTION OF EMBODIMENTS

Embodiments of the present disclosure will now be described with reference to the drawings. Note that the present disclosure is not limited by these embodiments. In addition, substantially identical components in the drawings are denoted by the same reference numerals. For illustrative purposes, the dimensions of each element in the drawings may be exaggerated and are not necessarily drawn to scale. For reference, the drawings schematically show mutually orthogonal X-, Y-, and Z-axes.

In the following, for convenience of explanation, terms indicating directions such as "up," "down," "right," "left," and "side" are used assuming a state during normal use, but are not intended to limit the state of use of the power generation module according to the present disclosure. Furthermore, in this specification, "orthogonal" means within a range of 90°±10°. "Parallel" means within a range of, for example, ±5°.

In the drawings described below, for reference, the mutually orthogonal X-axis, Y-axis, and Z-axis are schematically depicted. In the following description, when simply written as the X-direction, Y-direction, or Z-direction, it refers to the respective axial direction, and includes two opposite directions (for example, the -X-direction and the +X-direction).

≪First Embodiment≫

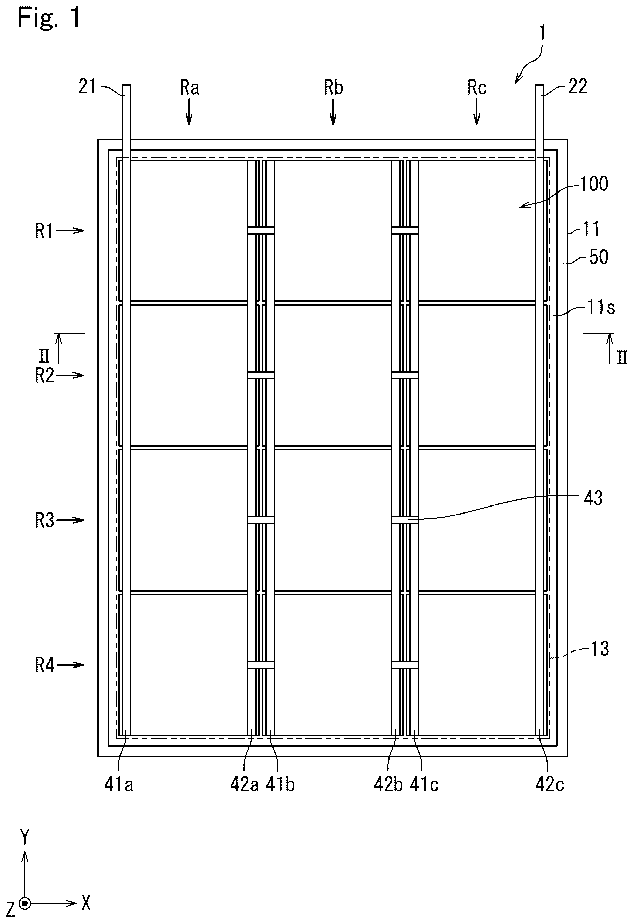

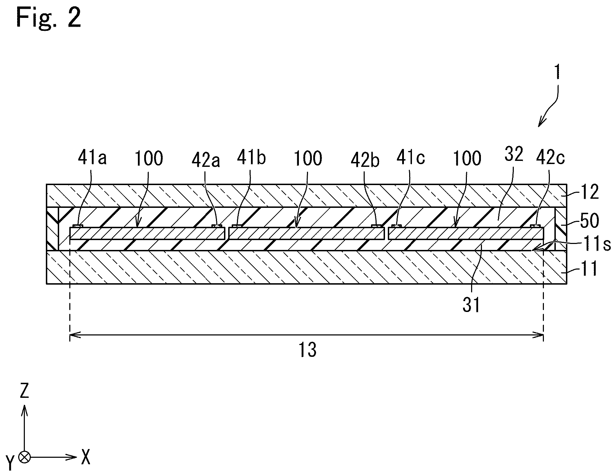

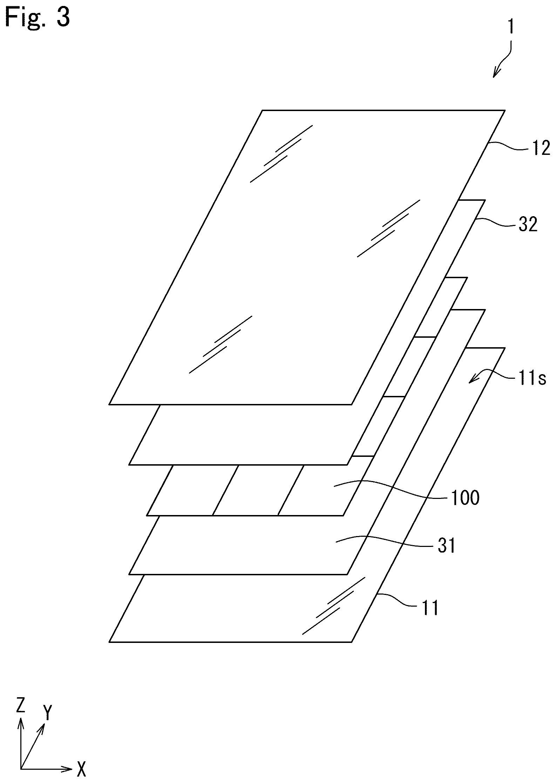

The basic configuration of a power generation module according to a first embodiment of the present disclosure will be described with reference to Figs. 1 to 3. Fig. 1 is a schematic top view of the power generation module according to the embodiment of the present disclosure. Fig. 2 is a schematic cross-sectional view of the power generation module of Fig. 1 taken along line II-II. Fig. 3 is a schematic exploded perspective view of the power generation module of Fig. 1.

As shown in Figs. 1 to 3, a power generation module 1 includes a first substrate 11, a second substrate 12, a plurality of submodules 100, a first filler 31, and a second filler 32.

In the following description, the power generation module 1 will be described as a power generation module that can be integrated with building materials such as windows of a building. The power generation module 1 can be used, for example, as a window that is arranged in a building so that external light enters from the second substrate 12 side.

The Z-direction (also referred to as the "first direction") shown in Figs. 1 to 3 corresponds to the thickness direction of the power generation module 1. The thickness direction of the power generation module 1 is, for example, the stacking direction of the two substrates 11, 12, or the stacking direction of the photovoltaic layers included in the power generation module 1. In addition, directions that intersect with each other (here, orthogonal) in a plane orthogonal to the Z-direction are defined as the X-direction and the Y-direction. The Y-direction may be, for example, the height direction of the window, and the X-direction may be, for example, the width direction of the window.

The first substrate 11 and the second substrate 12 have light-transmitting properties. "Light-transmitting properties" refers to transmissivity for visible light. "Have light-transmitting properties" means, for example, that the transmittance of visible light is 50% or more, preferably 70% or more. The first substrate 11 and the second substrate 12 are, for example, rectangular glass substrates (tempered glass substrates). As shown in Fig. 1, in the top view of the power generation module 1 or a portion thereof, the second substrate 12 may be omitted for clarity.

As shown in Fig. 2, the first substrate 11 and the second substrate 12 are disposed to face each other in the Z-direction. The second substrate 12, which is the light-receiving side, may be thinner than the first substrate 11. The peripheral edges of the first substrate 11 and the second substrate 12 are sealed by a sealing member 50. In a plan view seen along the Z-direction, the sealing member 50 is located outward of a central region 13 of the first substrate 11 in which the submodules 100 are arranged. The sealing member 50 can be made of a thermoplastic elastomer such as butyl rubber.

Each of the plural submodules 100 is a solar cell submodule having a solar cell (power-generating section). The plural submodules 100 are located between the first substrate 11 and the second substrate 12. Each submodule 100 has, for example, a rectangular planar shape. In the example shown in Fig. 1, the submodule 100 is disposed in a space surrounded by the first substrate 11, the second substrate 12, and the sealing member 50. The plural submodules 100 are disposed in the central region 13 of the first substrate 11 so as not to overlap each other in plan view seen along the Z-direction.

As shown in Fig. 2, the first filler 31 is located between the first substrate 11 and the lower surface of each submodule 100. The second filler 32 is located between the second substrate 12 and the upper surface of each submodule 100. These fillers 31 and 32 may be made of, for example, polyolefin (PO).

The fillers 31 and 32 may fill the space surrounded by the first substrate 11, the second substrate 12, and the sealing member 50. This can suppress the influence of air on the photovoltaic layer in the submodule 100. An air layer may be partially formed in the space. In this example, the fillers 31 and 32 are arranged above and below the submodule 100, but they may be arranged on only one side.

In this embodiment, the submodules 100 are arranged in a matrix in two directions (here, the X-direction and the Y-direction) that intersect (here, are orthogonal to) each other in plan view along the Z-direction. Columns Ra to Rc each consisting of a plurality of submodules arranged in the Y-direction are called "module columns." Rows R1 to R4 each consisting of a plurality of submodules arranged in the X-direction are called "module rows."

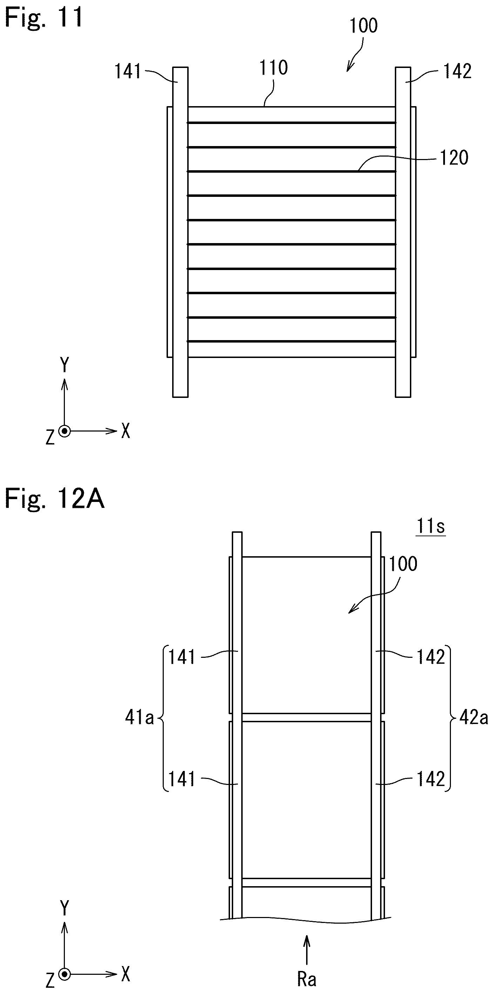

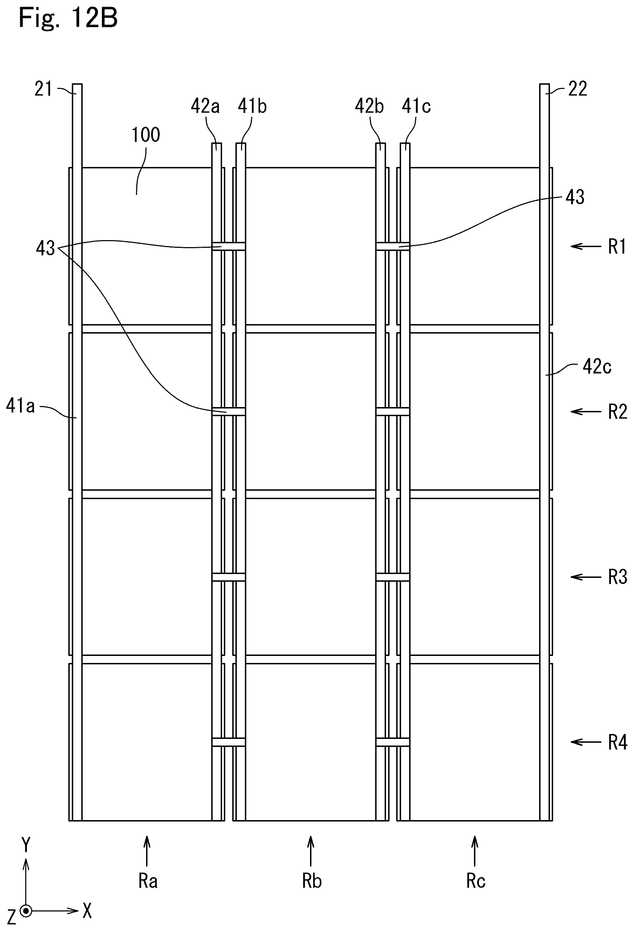

In the example shown in Fig. 1, 12 submodules 100 are arranged in four rows and three columns, constituting the four module rows R1 to R4 and the three module columns Ra to Rc. The plural (four in this example) submodules constituting each module column Ra to Rc are connected in parallel. The three module columns Ra to Rc are connected in series in the X-direction.

As shown in Fig. 1, the power generation module 1 further includes first wirings 41a to 41c and second wirings 42a to 42c extending in the Y-direction between the first substrate 11 and the second substrate 12, and a plurality of third wirings 43 for connecting adjacent first wirings and second wirings. These wirings may be metal wirings. In this embodiment, these wirings are wires (tab wires) made of copper wires coated with solder.

The first wiring 41a and the second wiring 42a connect the plural (four in this example) submodules 100 that make up the module column Ra in parallel. Similarly, the first wirings 41b, 41c and the second wirings 42b, 42c connect the plural submodules 100 that make up the module columns Rb, Rc in parallel. In the example shown, the first wirings 41a to 41c are arranged at one end of each of the module columns Ra to Rc in the X-direction. The second wirings (e.g., tab wires) 42a to 42c are arranged at the other end of each of the module columns Ra to Rc in the X-direction.

The plurality of third wirings 43 connects two adjacent module columns in series among the three module columns Ra to Rc, and are arranged so as to connect the first wiring of one of the two adjacent module columns to the second wiring of the other module column.

As shown in Fig. 1, the power generation module 1 further includes a pair of lead wires (positive and negative lead wires) 21, 22. The lead wires 21, 22 are, for example, metal wiring (e.g., tab wires). The lead wires 21, 22 are electrically connected to the submodules 100 within a space surrounded by the first substrate 11, the second substrate 12, and the sealing member 50. The lead wires 21, 22 may be drawn from within the space to the outside, passing through the sealing member 50.

In the example shown in Fig. 1, the lead wire 21 is electrically connected to one end of the first wiring 41a of the leftmost module column Ra. The lead wire 22 is electrically connected to one end of the second wiring 42c of the rightmost module column Rc. The lead wire 21 may be an extended portion of the first wiring 41a, and the lead wire 22 may be an extended portion of the second wiring 42c.

(Structure of Submodule 100)

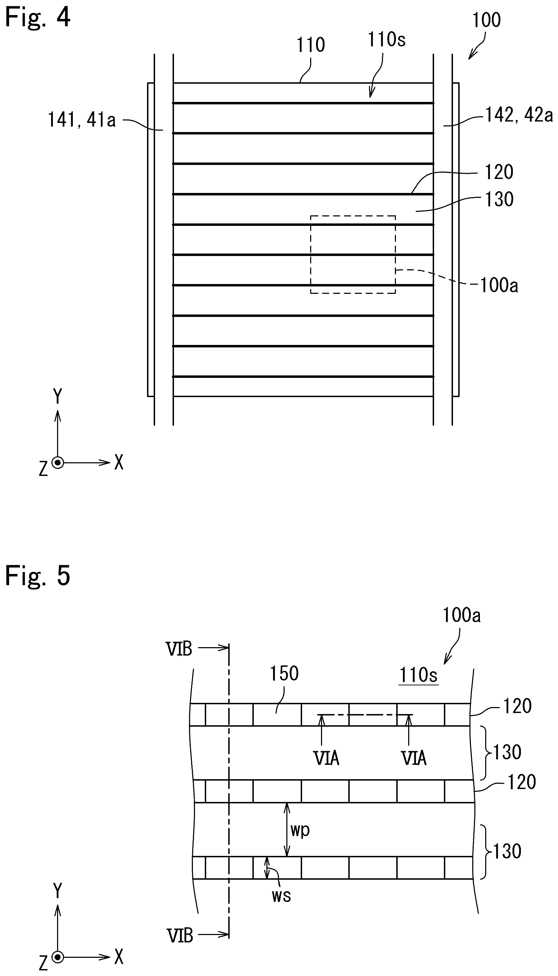

Referring to Figs. 4 to 6B, the structure of the submodule 100 in the power generation module 1 will be described. Here, one submodule in the module column Ra (Fig. 1) will be described as an example.

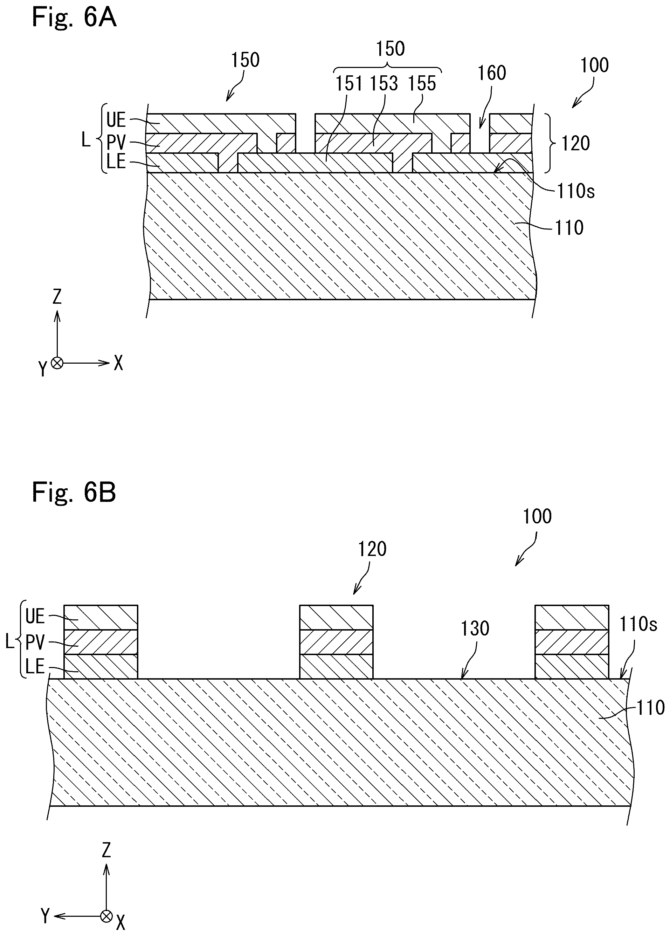

Fig. 4 is a schematic top view of one submodule in the power generation module. Fig. 5 is an enlarged top view of a portion of the submodule in Fig. 4. Fig. 5 shows an enlarged view of a region 100a shown in Fig. 4. Fig. 6A is an enlarged cross-sectional view taken along line VIA-VIA in Fig. 5. Fig. 6B is an enlarged cross-sectional view taken along line VIB-VIB in Fig. 5.

As shown in Fig. 4, each submodule 100 includes a base substrate 110 having light-transmitting properties, a power-generating section supported by the base substrate 110, and a pair of wirings 141, 142. In the example shown in Fig. 4, the power-generating section includes a plurality of linear strings 120.

The base substrate 110 is, for example, a rectangular glass substrate. The power-generating section is located on a part of a main surface 110s of the base substrate 110.

The power-generating section includes at least a photovoltaic layer. As described below, the power-generating section has a stacked structure including at least a pair of transparent electrodes and a photovoltaic layer located between the pair of transparent electrodes. The stacked structure only needs to be supported by the main surface 110s of the base substrate 110, and does not need to be in direct contact with the main surface 110s.

The wiring 141 is arranged on one end side of the base substrate 110. The wiring 142 is arranged on the other end side of the base substrate 110. In this example, the wirings 141, 142 are arranged at both ends of the base substrate 110 in the X-direction. The wirings 141, 142 are electrically connected to the power-generating section. The wirings 141, 142 are connected to the wirings 141, 142 of other submodules (not shown) adjacent in the Y-direction, respectively, to form the first wiring 41a and the second wiring 42a.

The plurality of strings 120, which are power-generating sections, are connected in parallel by the wirings 141, 142. Here, each string 120 extends in the X-direction from one end to the other end of the base substrate 110. One end of each string 120 is connected to the wiring 141, and the other end is connected to wiring 142.

The plural strings 120 are arranged on the main surface 110s of the base substrate 110 at a distance from each other in the Y-direction. In plan view seen along the Z-direction, the plural strings 120 may extend parallel to each other, for example. In plan view seen along the Z-direction, regions 130 of the main surface 110s of the base substrate 110 located between adjacent strings 120 are referred to as "inter-string regions."

As shown in Figs. 5 and 6, each of the plurality of strings 120 is a solar cell element string having a plurality of solar cell elements 150 connected in series.

As shown in Figs. 6A and 6B, each string 120 has a stacked structure L in the Z-direction, including a lower transparent conductive layer LE, a photovoltaic layer PV, and an upper transparent conductive layer UE. These layers are supported by the main surface 110s. In the stacked structure L, the photovoltaic layer PV is located between the lower transparent conductive layer LE and the upper transparent conductive layer UE. The lower transparent conductive layer LE is located on the base substrate 110 side of the photovoltaic layer PV. The photovoltaic layer PV may further include an electron transport layer and/or a hole transport layer as necessary. The photovoltaic layer PV is, for example, a laminated film including, from the base substrate 110 side, an n-type semiconductor layer, an i-type semiconductor layer, and a p-type semiconductor layer.

The lower transparent conductive layer LE, photovoltaic layer PV, and upper transparent conductive layer UE are separated for each solar cell element 150. In this example, the photovoltaic layer PV and the upper transparent conductive layer UE are separated for each solar cell element 150 by a separation groove 160. The lower transparent conductive layer LE includes a lower transparent electrode 151 of each solar cell element 150. The upper transparent conductive layer UE includes an upper transparent electrode 155 of each solar cell element 150. The photovoltaic layer PV includes a semiconductor layer 153 of each solar cell element 150.

Each solar cell element 150 has the lower transparent electrode 151, the upper transparent electrode 155, and the semiconductor layer 153 located between the lower transparent electrode 151 and the upper transparent electrode 155. The lower transparent electrode 151 (or the upper transparent electrode 155) of the solar cell element 150 located at one end of each string 120 is electrically connected to the wiring 141. Similarly, the upper transparent electrode 155 (or the lower transparent electrode 151) of the solar cell element 150 located at the other end of each string 120 is electrically connected to the wiring 142.

The photovoltaic layer PV (i.e., the semiconductor layer 153) is a layer (photoelectric conversion layer) that converts absorbed light into electricity. The photovoltaic layer PV includes, for example, a perovskite compound (perovskite semiconductor) as a photoelectric conversion material. The perovskite compound is a perovskite crystal structure represented by the chemical formula ABX3 or a structure having a crystal similar thereto. A is a monovalent cation, B is a divalent cation, and X is a halogen anion. The lower transparent conductive layer LE and the upper transparent conductive layer UE are, for example, metal oxide layers having light-transmitting properties such as indium tin oxide (ITO), indium zinc oxide (IZO), or fluorine-doped tin oxide (FTO) layers. Note that the materials of each layer constituting the solar cell element are not limited to those described above, and known materials may be used.

(Power-Generating Section Area Ratio of Submodule 100)

Reference is made again to Figs. 4 and 5. In this specification, the ratio of the area of the power-generating section to the area of the main surface 110s of the base substrate 110 in plan view along the Z-direction is referred to as the "power-generating section area ratio." In the example shown in Fig. 4, the "area of the power-generating section" is the total area of the plural strings 120 in plan view along the Z-direction. The power-generating section area ratio is, for example, substantially equal to the ratio of the area of the portion where the photovoltaic layer PV (or photovoltaic film) is present to the area of the main surface 110s in plan view along the Z-direction (hereinafter referred to as the "photovoltaic layer area ratio"). Hence, the power-generating section area ratio can also be said to be the photovoltaic layer area ratio.

In the submodule 100, the light transmittance of the power-generating section for visible light incident in the Z-direction is lower than the light transmittance of the portion where the power-generating section is not formed. This is because the power-generating section includes a photovoltaic layer PV, which has a lower visible light transmittance than, for example, a glass substrate. Thus, by changing the power-generating section area ratio, it is possible to adjust the light transmittance of the entire submodule 100. Note that in this specification, "light transmittance" refers to the transmittance (visible light transmittance) for visible light (wavelength 400 nm to 700 nm) incident on the power generation module 1 along the first direction (Z-direction).

In the example shown in Fig. 5, the power-generating section area ratio can be adjusted by the number of strings 120 arranged in the submodule 100, the width of each string 120 along the second direction (hereinafter referred to as the "string width") ws, the distance (hereinafter referred to as the "inter-string distance") between two adjacent strings 120 along the second direction (Y-direction), and the like. The inter-string distance refers to the width (hereinafter referred to as the "inter-string region width") wp of an inter-string region 130 along the second direction. As an example, the power-generating section area ratio of each submodule 100 can be appropriately selected within a range of, for example, 20 to 80%. This allows the light transmittance of each submodule 100 to be adjusted to a desired value within a range of, for example, 20 to 80%.

(Arrangement of Submodules in Power Generation Module)

The power generation module 1 of this embodiment includes two submodules adjacent in the second direction when viewed in plan view from the first direction (Z-direction). The two adjacent submodules are configured to have different power-generating section area ratios. In this specification, the submodule with the smaller power-generating section area ratio may be referred to as the "first submodule," and the submodule with the larger power-generating section area ratio may be referred to as the "second submodule." The first submodule may have a higher light transmittance than the second submodule.

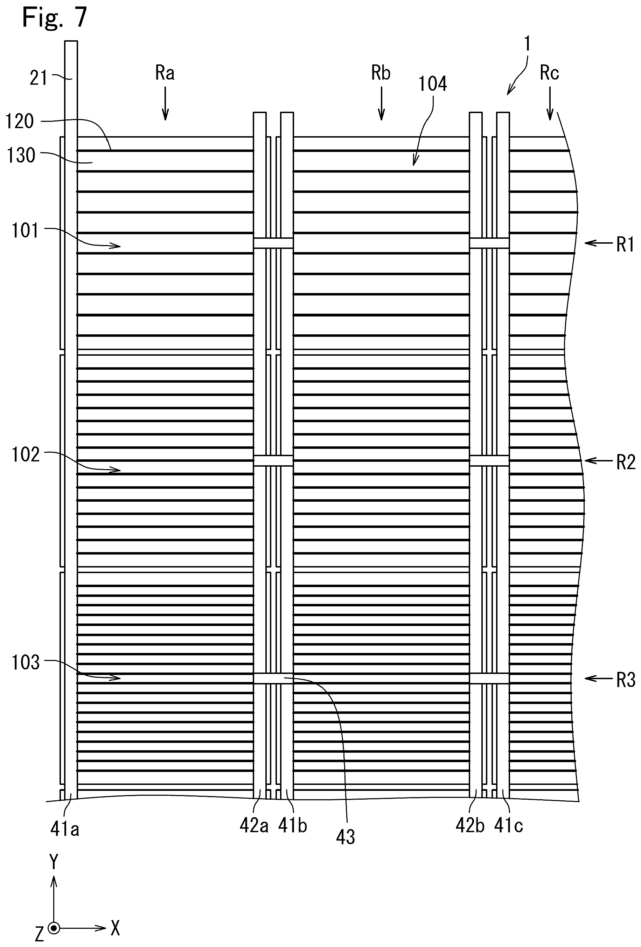

Fig. 7 is an enlarged top view showing a part of the power generation module of Fig. 1. Fig. 7 shows an enlarged view of submodules 100 belonging to three rows and three columns located in the upper left corner, of the submodules 100 shown in Fig. 1.

Description will be given using as an example two submodules 101 and 102 in the module column Ra shown in Fig. 7. The submodules 101 and 102 are adjacent to each other in the second direction (here, the Y-direction) in plan view seen from the first direction (the Z-direction). In this example, the submodules 101 and 102 are connected in parallel to each other.

The power-generating section area ratio of the submodule 101 is smaller than the power-generating section area ratio of the submodule 102. That is, in this example, the submodule 101 corresponds to the "first submodule" and the submodule 102 corresponds to the "second submodule." This allows the light transmittance of the submodule 101 to be greater than the light transmittance of the submodule 102.

In the example shown in Fig. 7, the strings 120 are arranged at equal intervals in the Y-direction in each of the submodules 101 and 102. The strings 120 are arranged more densely in the submodule 102 than in the submodule 101. Therefore, the number of the strings 120 in the submodule 102 is greater than the number of the strings 120 in the submodule 101. The width of the strings 120 in the Y-direction is, for example, all constant. In this way, the power-generating section area ratio of the submodule 102 (here, the ratio of the total area of the strings 120 to the main surface 110s) can be set to be greater than that of the submodule 101.

The power generation module 1 further includes a submodule 103 arranged on the side of the submodule 102 opposite to the submodule 101 in the second direction (here, the Y-direction) in plan view seen along the Z-direction. The submodule 103 may be referred to as a "third submodule." The power-generating section area ratio of the submodule 102 is smaller than the power-generating section area ratio of the submodule 103. In this example, the strings 120 are arranged more densely in the submodule 103 than in the submodule 102.

As illustrated in Fig. 7, the submodules 100 constituting each of the module columns Ra to Rc may be configured so that the power-generating section area ratio decreases as the submodule approaches one end of the module column (here, the upper end (+Y side)). This allows the light transmittance to be changed along the Y-direction (e.g., the height direction of the window).

The power generation module 1 further includes a submodule 104 arranged adjacent to the submodule 101 in a third direction (here, the X-direction) intersecting the second direction in plan view along the Z-direction. The submodule 104 may be referred to as "fourth submodule." The power-generating section area ratio of the submodule 104 is equal to the power-generating section area ratio of the submodule 101. In this example, the number of the strings 120 of the submodule 104 is the same as that of the first submodule 101.

As illustrated in Fig. 7, the submodules 100 constituting each of the module rows R1 to R4 may all be configured to have the same power-generating section area ratio. This makes it possible to maintain a constant transmittance along the X-direction (e.g., the width direction of the window).

(Another Example of Submodule Arrangement)

The power generation module of this embodiment may include at least two submodules adjacent to each other in the second direction and having different power-generating section area ratios. In Fig. 7, the first submodule is located above (on the +Y side of) the second submodule, but it may also be located below (on the -Y side of) it. Also, in Fig. 7, the second direction is described as the Y-direction, but the second direction may be any direction (any direction on the XY plane) that intersects with the first direction, which is the thickness direction of the power generation module 1. The number and arrangement of the submodules are not limited to the example shown in Fig. 7. In Fig. 7, the submodules 100 are arranged in a matrix, but the submodules 100 may also be arranged in only one direction.

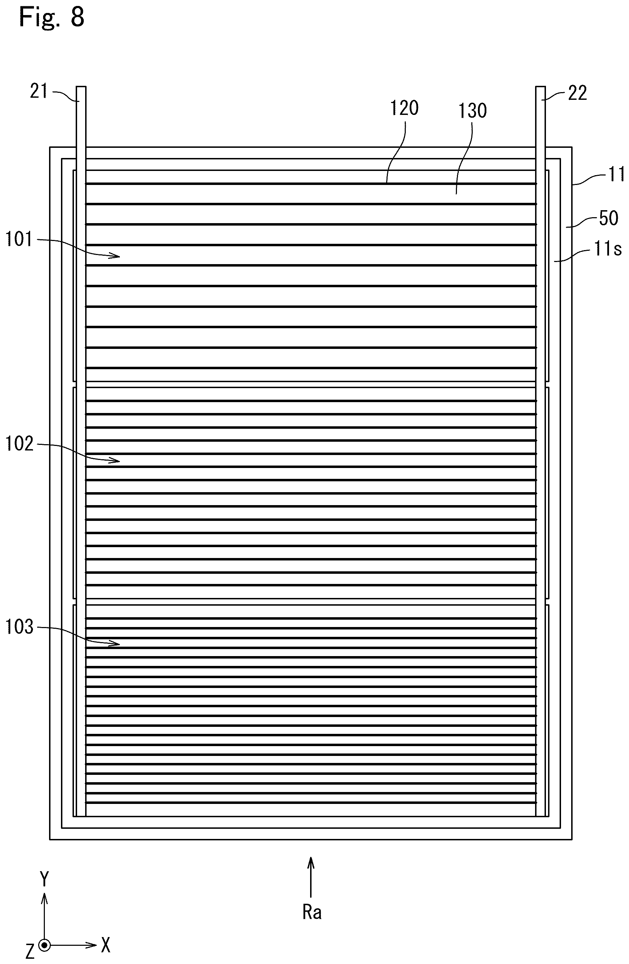

Fig. 8 is a schematic top view showing another example of the power generation module of the first embodiment.

The power generation module shown in Fig. 8 differs from the configuration shown in Fig. 2 in that it includes a single module column including a plurality of (here, three) submodules 101 to 103.

Similar to the submodules 101 to 103 shown in Fig. 7, the submodules 101 to 103 are configured such that the submodules located closer to one end of the module column Ra (here, the +Y side) have a higher power-generating section area ratio. Therefore, the light transmittance of the power generation module gradually increases in the +Y-direction. As shown in the figure, depending on, for example, the size of the window, the planar shape of each of the submodules 101 to 103 may be a rectangle elongated in the X-direction. This configuration makes it possible to provide a power generation module that is simple and has an excellent appearance, without the need to arrange wiring between the submodules.

(Submodule Manufacturing Method)

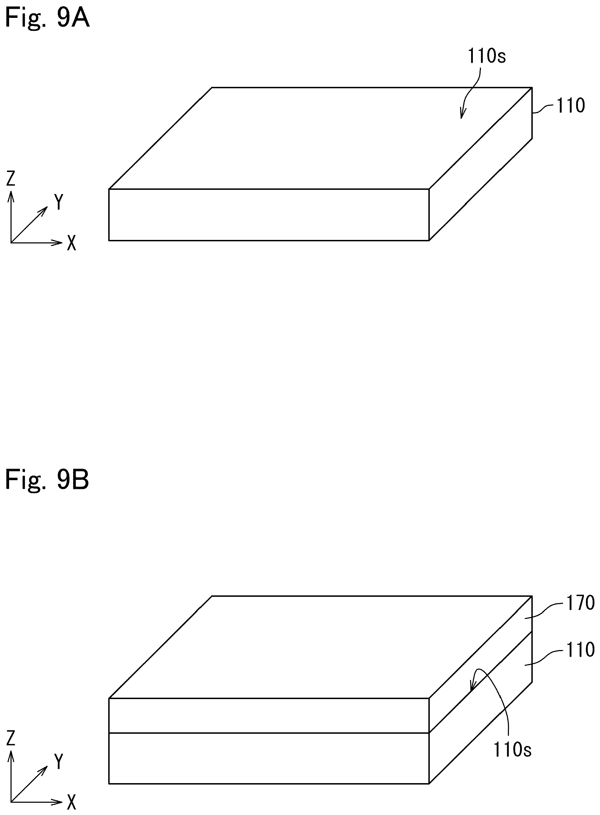

A method for manufacturing the submodule 100 will be described with reference to Figs. 9A to 11.

The manufacturing method of the submodule 100 includes a film formation step in which the laminated film including a photovoltaic film is formed on the main surface of the base substrate, a film processing step in which the laminated film is processed to form a power-generating section, and a wiring formation step in which wiring is arranged to electrically connect to the power-generating section.

·Film Formation Step

Figs. 9A and 9B are each a schematic process perspective view for explaining the film formation step.

First, as shown in Fig. 9A, the base substrate 110 having light-transmitting properties is prepared. In this example, a glass substrate is prepared as the base substrate 110. Alternatively, a substrate whose surface is covered with a transparent conductive film, such as an FTO substrate, may be used.

Next, as shown in Fig. 9B, a laminated film 170 including a lower transparent conductive film, a photovoltaic film, and an upper transparent conductive film in this order from the main surface 110s side of the base substrate 110 is formed on the main surface 110s.

Each film in the laminated film 170 is formed by a known method and patterned as necessary. For example, patterning of the lower transparent conductive film, formation of a contact portion connecting the upper transparent conductive film and the lower transparent conductive film, etc. may be performed as appropriate. When a substrate whose surface is covered with a transparent conductive film, such as an FTO substrate, is used, the transparent conductive film on the substrate surface may be used as the lower transparent conductive film in the laminated film 170.

The photovoltaic film includes, for example, a perovskite compound. The photovoltaic film is applied onto the lower transparent conductive film formed on the main surface 110s by a method such as spin coating or inkjet printing. The photovoltaic film is, for example, a laminated film including an n-type semiconductor film, an i-type semiconductor film (perovskite layer), and a p-type semiconductor film. First, the n-type semiconductor film is applied using an inkjet printing method and dried, and then the i-type semiconductor film that will become the upper layer is applied using an inkjet printing method and dried. Similarly, the p-type semiconductor film is applied using an inkjet printing method and dried to form a laminated film. The laminated film that will become the photovoltaic film may be formed by repeating the application and drying in this manner.

·Film Processing Step

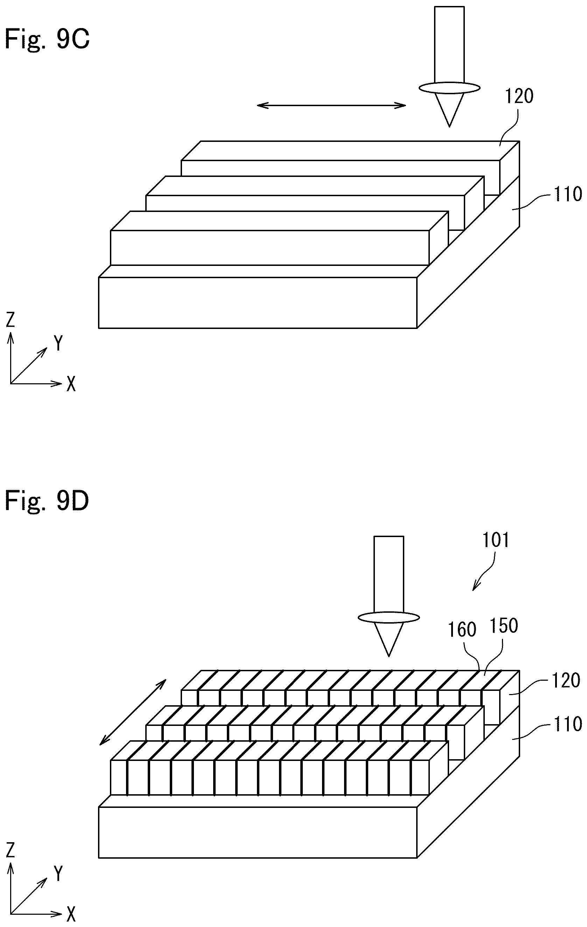

In the film processing step, first, as shown in Fig. 9C, a laser beam is scanned in the X-direction to perform a first laser processing step (string formation step) on the laminated film 170 formed by the above method, and a portion of the laminated film 170 is removed from the main surface 110s. Here, a scribing process such as laser scribing is performed. The portion of the laminated film 170 that is not removed and remains on the main surface 110s becomes the power-generating section (string 120).

Next, as shown in Fig. 9D, a second laser processing step (element separation step) is performed by scanning a laser beam in the Y-direction. As a result, a plurality of separation grooves 160 (corresponding to the separation grooves 160 in Fig. 6A) extending in the Y-direction are formed in each string 120, separating the string into the plurality of solar cell elements 150. In this way, the stacked structure L illustrated in Fig. 6A is obtained.

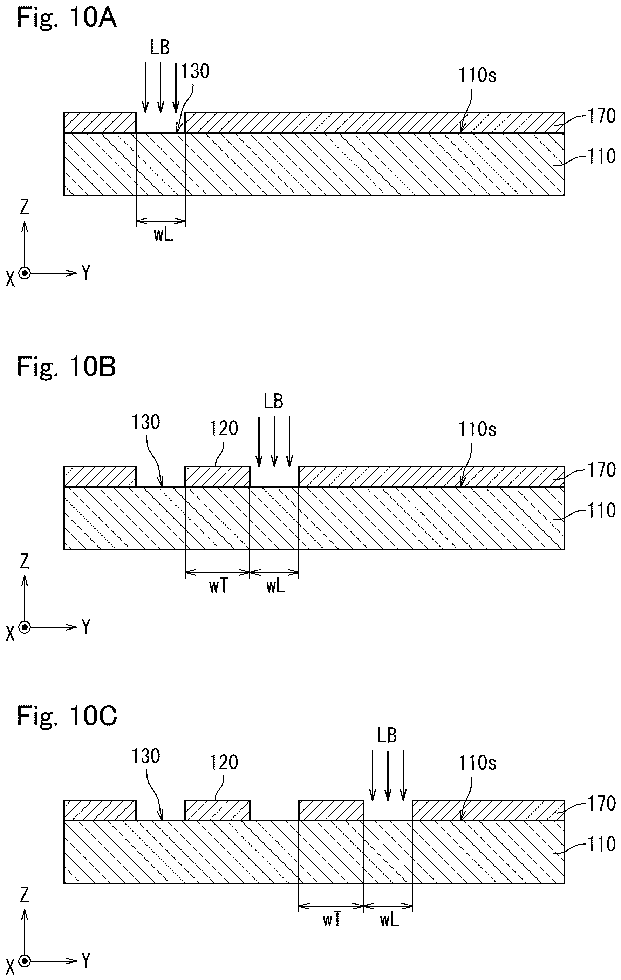

The first laser processing step (Fig. 9C) will be described in more detail below with reference to Figs. 10A to 10C. Here, an example will be described in which the lower transparent conductive film, photovoltaic film, and upper transparent conductive film constituting the laminated film 170 are all removed simultaneously by laser processing. It is sufficient that at least a portion of the photovoltaic film is removed from the base substrate by laser processing. The other transparent conductive films may be processed by a method different from that for the photovoltaic film and may have a different pattern.

Figs. 10A to 10C are schematic process cross-sectional views illustrating the film processing step.

As shown in Fig. 10A, the laser beam LB is scanned in the X-direction to irradiate the laminated film 170 with the laser beam LB over a predetermined irradiation range (referred to as the "irradiation width") wL. This removes the irradiated portion of the laminated film 170. The removed portion becomes a linear region (inter-string region) 130 extending in the X-direction. If the irradiation width wL is wide, plural scans may be performed to irradiate the predetermined range wL. In this example, the laminated film 170 is removed throughout the thickness direction, exposing a portion of the main surface 110s.

Next, as shown in Fig. 10B, the laser head is moved to shift the irradiation position of the laser beam LB in the Y-direction by a predetermined distance (referred to as the "non-irradiation width") wT. In this state, the laser beam LB is scanned in the X-direction to irradiate the laminated film 170 with the laser at an irradiation width wL, thereby removing a portion of the laminated film 170. Between two removed portions adjacent in the Y-direction, a line-shaped stacked structure, i.e., the string 120, having the same width as the non-irradiation width wT is formed. As shown in Fig. 10C, the laminated film 170 is then irradiated with the laser while continuing to shift the irradiation position in the Y-direction. In this manner, the plurality of strings 120 can be formed on the main surface 110s, equally spaced in the Y-direction.

In this embodiment, in the film processing step, a first submodule (e.g., submodule 101 in Fig. 7) and a second submodule (e.g., submodule 102 in Fig. 7) are fabricated by varying the processing conditions in the first laser processing step. This allows the removal area (total area) of the photovoltaic film to be different, making it possible to separately fabricate two submodules with different light transmittances.

The irradiation width wL and non-irradiation width wT of the laser beam LB can be appropriately set so as to obtain a desired light transmittance and power generation amount. For example, the irradiation width wL1 of the laser beam LB when manufacturing the first submodule may be larger than the irradiation width wL2 when manufacturing the second submodule. Alternatively, the non-irradiation width wT1 when manufacturing the first submodule may be smaller than the non-irradiation width wT2 when manufacturing the second submodule. An example of a method for separately fabricating the submodules 101 and 102 will be described with reference to Figs. 9A to 9F.

First, a plurality of base substrates 110 smaller in size than the first substrate 11 are prepared (Fig. 9A). The laminated film 170 is formed on the main surface 110s of each of these substrates 110 under the same lamination conditions, and a plurality of base submodules (hereinafter, "base submodules with laminated film") are prepared (Fig. 9B).

Next, as shown in Fig. 9C, the base submodule with the laminated film is subjected to the first laser processing step (string formation step) under first processing conditions (irradiation width wL1 and non-irradiation width wT1). This forms the plurality of strings 120 on the base substrate 110, each with a string width wT1 and an inter-string distance wL1. Next, as shown in Fig. 9D, a second laser processing step (element separation step) is performed to form a submodule. This becomes the "first submodule 101."

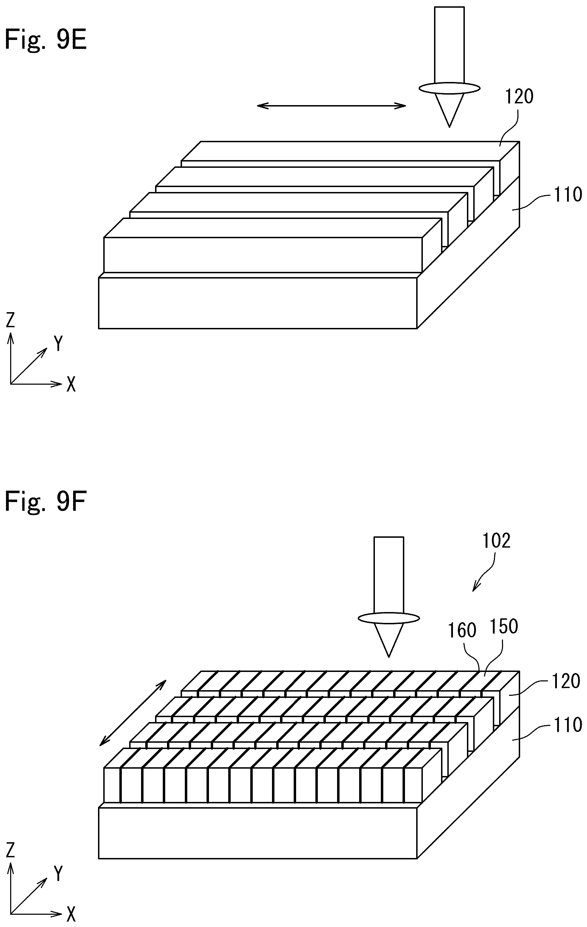

Similarly, as shown in Fig. 9E, the base submodule with the laminated film (Fig. 9B) is processed under second processing conditions (irradiation width wL2 (wL2<wL1), non-irradiation width wT2 (wT2=wT1)) that are different from the first processing conditions. This forms the plurality of strings 120 on the base substrate 110, each with a string width wT2 (=wT1) and an inter-string distance of wL2 (<wL1). Next, as shown in Fig. 9F, a second laser processing step (element separation step) is performed to form a submodule. This becomes the "second submodule 102."

In this way, the second processing conditions for forming the second submodule are set to the same non-irradiated width as the first processing conditions, while setting only the irradiated width to be smaller, thereby forming the second submodule 102. The laser output for the laser processing is the same under both the first and second processing conditions.

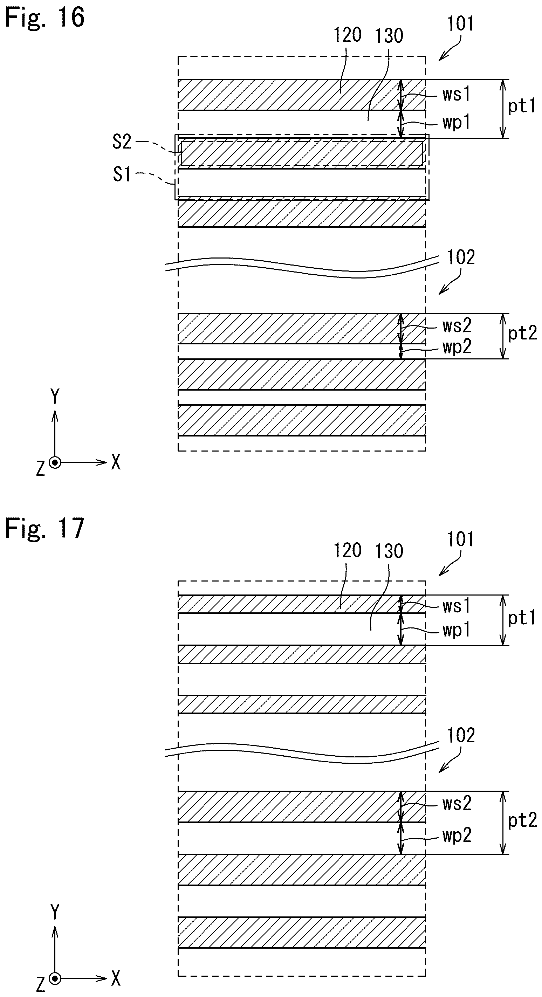

The first and second submodules formed under these conditions have the relationship shown in Table 1 (see Fig. 16). These submodules have the same string width, but different inter-string region widths.

In this way, by forming the laminated film 170 on the base substrate 110 under common formation conditions in advance and fabricating plural base submodules (base submodules with laminated film), the first submodule 101 and the second submodule 102 can be manufactured from the base submodule by changing the processing conditions of the first laser processing step.

·Wiring Formation Step

Fig. 11 is a schematic top view illustrating the wiring formation step. As shown in Fig. 11, the wirings (e.g., tab wires) 141, 142 are formed on the base substrate 110 on which the strings 120 have been formed by the above method. In this manner, the submodule 100 is manufactured.

The wirings 141, 142 are respectively disposed on one end and the other end of the substrate 110 in the X-direction. In plan view seen along the Z-direction, the wirings 141, 142 are longer than the length of the substrate 110 in the Y-direction, and the upper and lower ends of the wirings 141, 142 may extend outside the substrate 110. The wiring 141 is connected to the upper or lower transparent conductive layer at the left end of each string 120 at one end of the base substrate 110. Similarly, the wiring 142 is connected to the upper or lower transparent conductive layer at the right end of each string 120 at the other end of the base substrate 110. Each of the wirings 141, 142 may be connected to the upper surface of the end of the lower transparent conductive layer by, for example, soldering.

(Method for Manufacturing Power Generation Module)

Next, a method for manufacturing the power generation module 1 using the submodule 100 (Fig. 11) manufactured by the above method will be described with reference to Figs. 12A to 13C.

The method for manufacturing the power generation module includes, for example, a submodule arrangement step in which plural submodules are arranged on a first substrate and electrically connected to each other, and a sealing step in which the first substrate and a second substrate are bonded together with the plural submodules in between.

·Submodule Arrangement Step

Figs. 12A and 12B are schematic process top views explaining the submodule arrangement step.

First, a first substrate (e.g., a glass substrate) is prepared, and a plurality of submodules 100 are arranged on the first surface 11s of the first substrate via a filler (filler 31 shown in Fig. 2, etc.). For example, a filler sheet containing polyolefin is used as the filler. Here, 12 submodules 100 may be arranged in four rows and three columns.

In this embodiment, as shown in Fig. 12A, the wirings 141 and the wirings 142 of two submodules 100 adjacent in the Y-direction (column direction) are connected using, for example, solder. The wirings 141 of the submodules 100 in the same column are connected in the Y-direction to form the first wiring 41a extending in the Y-direction. Similarly, the wirings 142 of the submodules 100 in the same column are connected in the Y-direction to form the second wiring 42a extending in the Y-direction. This results in the module column Ra in which the submodules 100 in the same column are connected in parallel. Similarly, in the other module columns Rb, Rc, the first wirings 41b, 41c and second wirings 42b, 42c are formed to connect four submodules 100 in parallel.

As shown in Fig. 12B, the second wiring 42a of the module column Ra and the first wiring 41b of the module column Rb are electrically connected by the third wiring 43. The third wiring (e.g., a tab wire) 43 may be connected to the second wiring 42a and the first wiring 41b by, for example, soldering. Similarly, the second wiring 42b of the module column Rb and the first wiring 41c of the module column Rc are connected by the third wiring 43. This connects the module columns Ra to Rc in series.

Substantially, the lead wire 21 is connected to the first wiring 41a of the leftmost module column Ra, and the lead wire 22 is connected to the second wiring 42c of the rightmost module column Rc. In this way, a first substrate with submodules is formed.

In this example, at least one third wiring 43 is arranged between two submodules 100 adjacent in the X-direction, but the number and arrangement (position in the Y-direction) of the third wiring 43 are not limited to the example shown in the figure.

·Sealing Step

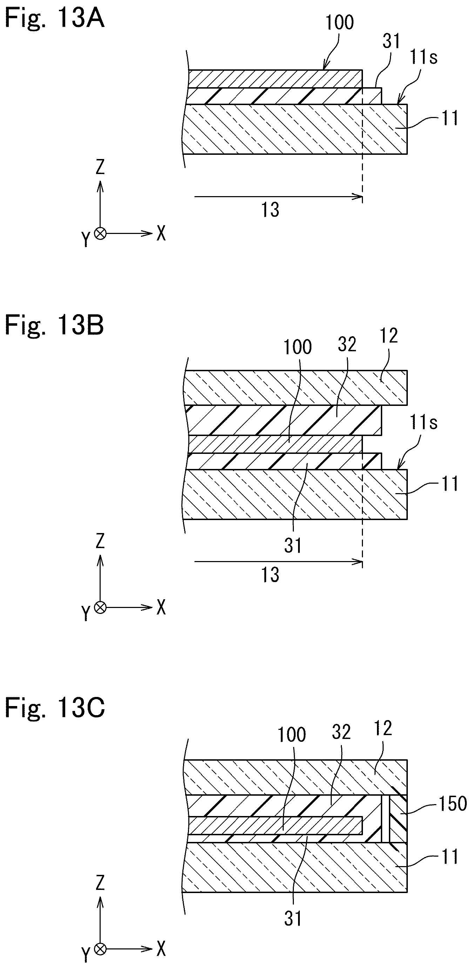

Figs. 13A to 13C are schematic process cross-sectional views for explaining the sealing step. Fig. 13A shows the state in which the submodules 100 are arranged on the first surface 11s of the first substrate 11 via the filler 31 by the method described above.

As shown in Fig. 13B, the second substrate 12 is placed above the submodule 100 shown in Fig. 13A via the filler 32. For example, a filler sheet containing polyolefin is used as the filler 32. In plan view from the Z-direction, the fillers 31 and 32 may have a size larger than the central region 13 in which the submodule 100 is placed. In plan view seen along the Z-direction, the periphery of the filler sheet may be located between the outer edge of the central region 13 and the peripheries of the first substrate 11 and the second substrate 12.

After this, lamination is performed. In the lamination process, as shown in Fig. 13C, the fillers 31 and 32 melt under reduced pressure and flow around to cover the side surfaces of the submodule 100 (the side surfaces close to the edges of the first substrate 11), bonding the first substrate 11 and the second substrate 12 together. This reduces the likelihood of an air layer remaining near the side surfaces of the submodule 100, thereby suppressing the influence of air on the photovoltaic layer. As shown in the figure, the entire side surfaces of the submodule 100 may be covered with the fillers 31 and 32. Next, a sealing member (e.g., butyl rubber) 50 is disposed between the first substrate 11 and the second substrate 12, outside the central region 13, thereby sealing the space between the first substrate 11 and the second substrate 12. The sealing member 50 is disposed, for example, so as to surround the central region 13. The sealing member 50 may also be disposed outside the fillers 31 and 32. In this manner, the power generation module 1 is manufactured.

In the above, the sealing member 50 is disposed and sealed after lamination, but the lamination may be performed after the sealing member 50 is disposed and sealed.

(Setting Light Transmittance of Submodule)

As described above, in this embodiment, the light transmittance of the submodule can be adjusted by adjusting the total area of the photovoltaic film removed when manufacturing each submodule.

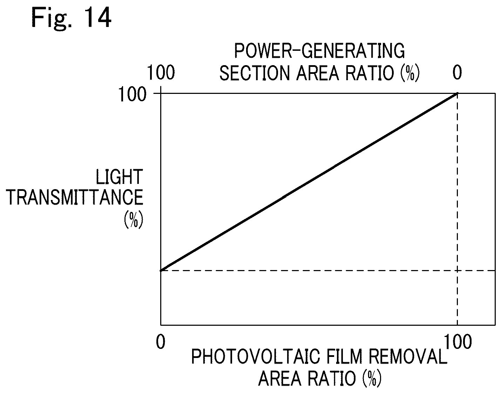

Fig. 14 is a schematic diagram showing the relationship between the photovoltaic film removal area ratio and power-generating section area ratio of the submodule and the light transmittance in the thickness direction (Z-direction) of the submodule.

The "light transmittance" on the vertical axis of the graph shown in Fig. 14 is the light transmittance excluding the wiring (tab wires) formed on both ends of the submodule. The "photovoltaic film removal area ratio" is the ratio of the area of the photovoltaic film removed by laser processing or the like to the main surface of the base substrate. A photovoltaic film removal area ratio of 0% refers to a state in which the photovoltaic film is formed over the entire main surface of the base substrate. The power-generating section area ratio at this time is, for example, 100%. A photovoltaic film removal area ratio of 100% refers to a state in which the photovoltaic film has been removed from the entire main surface of the base substrate and no photovoltaic film remains, and the power-generating section area ratio is 0%.

As can be seen from Fig. 14, the light transmittance increases as the area of the photovoltaic film removed increases. In other words, the light transmittance increases as the power-generating section area ratio decreases. The light transmittance of the submodule when all of the photovoltaic film is removed is approx. 100%, ignoring the light transmittance of the first and second substrates. The relationship between light transmittance and the area ratio of the photovoltaic film removed shown in Fig. 14 is an example, and may vary depending on the material, thickness, and formation method of the photovoltaic film, the structure of the power-generating section, etc.

By utilizing the relationship shown in Fig. 14, it is possible to set the light transmittance for each submodule.

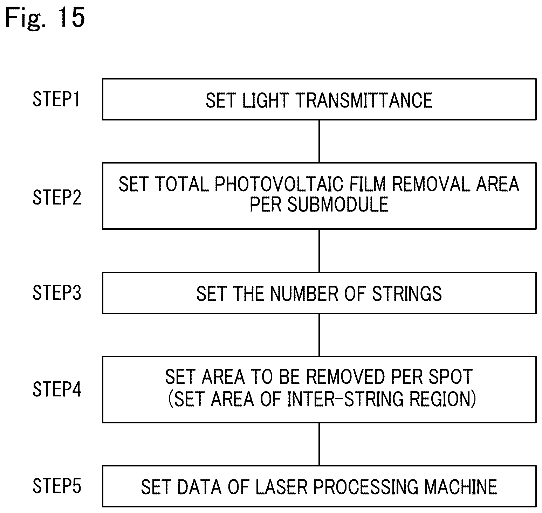

Fig. 15 is a flowchart showing an example of a method for setting the light transmittance of a submodule. Here, an example will be described in which a submodule is designed with the width of each string set to a constant value.

First, the light transmittance (target value) of the submodule is set according to requirements such as the use, design quality, and power generation amount (power generation efficiency per unit area) of the power generation module (STEP 1).

Next, the total area of the photovoltaic film to be removed is set based on the target value of light transmittance (STEP 2). For a photovoltaic film made of the same material as the photovoltaic film used in the submodule, the relationship between the photovoltaic film removal area ratio and light transmittance may be determined in advance, as shown in Fig. 14. The removal area can be set based on this relationship.

Next, the number of the strings is set based on the removal area (STEP 3). Furthermore, the area of the photovoltaic film to be removed by one laser irradiation (i.e., the area of the inter-string region) is set (STEP 4). Based on this setting, data for the laser processing machine (laser irradiation position, irradiation width, etc.) is set (STEP 5).

In the above method, the string width is designed to be constant, but the width of the inter-string region may also be designed to be constant. Alternatively, the string array pitch may be designed to be constant. The string width is the width determined based on, for example, the non-irradiated width wT shown in Figs. 10A to 10C. The inter-string region width is the width determined based on the irradiated width wL shown in Figs. 10A to 10C.

(Example of String Structure of First and Second Submodules)

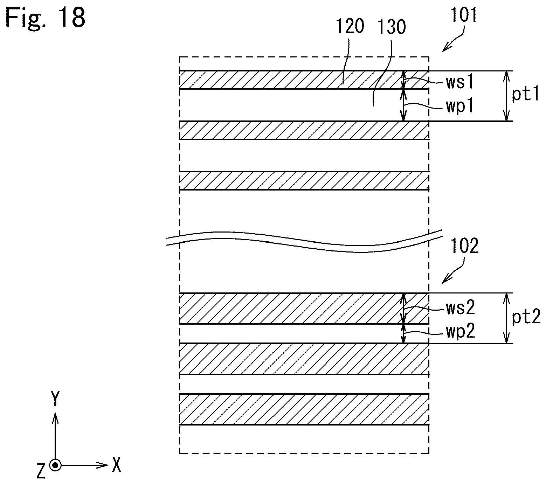

An example of the string structure will be described with reference to Figs. 16 to 18. Figs. 16 to 18 are schematic enlarged top views of two adjacent submodules 101 and 102. Wiring is not shown in these figures.

The string structures shown in Figs. 16 to 18 are referred to as the first string structure to the third string structure, respectively. The overview of each structure is shown in Table 1. Table 1 shows the relationship between the string width ws1, the width (inter-string region width) wp1 of the inter-string region, the number (total number) N1 of the strings, and an array pitch pt1 of the first submodule 101, and the string width ws2, the width of the inter-string region wp2, the number N2 of the strings, and an array pitch pt2 of the second submodule 102 for each structure. The "array pitch" here refers to the distance between the top ends of two strings 120 adjacent in the Y-direction, and is a distance equivalent to the sum of the string width and the inter-string region width.

[Table 1]

|  | 1st String Structure | 2nd String Structure | 3rd String Structure |
|---|---|---|---|
| String Width | ws1=ws2 | ws1<ws2 | ws1<ws2 |
| Inter-String Region Width | wp1>wp2 | wp1=wp2 | wp1>wp2 |
| Number of Strings | N1<N2 | N1>N2 | N1=N2 |
| Array Pitch | pt1>pt2 | pt1<pt2 | pt1=pt2 |

According to the first string structure, by making the string widths ws1, ws2 of the submodules 101, 102 identical, it is possible to obtain the same power generation output from each string 120 in the submodules 101, 102.

The second string structure has the advantage that by making the inter-string region widths wp1 and wp2 of the submodules 101 and 102 identical, the two submodules 101 and 102 can be manufactured under the same processing conditions (laser irradiation width) in the process of processing the photovoltaic film.

In the third string structure, the array pitch pt of the strings 120 is constant in the two submodules 101 and 102, but the string width and the width of the inter-string region are different from each other, which makes it easier to design each submodule.

In the first to third string structures, the string area ratio is constant for each pitch in each of the submodules 101, 102. As illustrated in Fig. 16, the "string area ratio" refers to the ratio of the area S2 of the string 120 to the total area S1 of the string 120 and the inter-string region 130 adjacent to that string 120 in the second direction (for example, the -Y-direction). Therefore, when the array pitches pt1, pt2 are sufficiently small relative to the length of the main surface in the Y-direction, the light transmittance is substantially uniform within each of the submodules 101, 102.

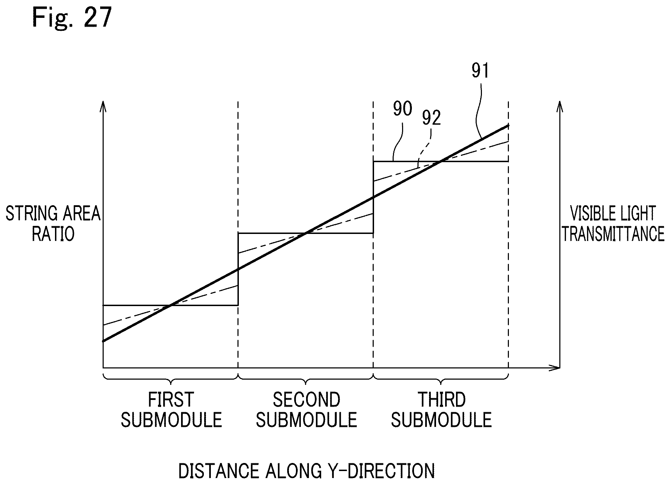

The first to third string structures can be applied to the module column Ra (Fig. 7) including three or more submodules 101 to 103 arranged in the Y-direction. This makes it possible to vary the light transmittance in the Y-direction in the module column Ra, as shown by line 90 in Fig. 27. In other words, in this embodiment, a gradation is formed not in each submodule but in the entire module column Ra.

The configuration of the power generation module in this embodiment is not limited to the illustrated example. For example, in the top view shown in Fig. 2, the Y-direction may be the width direction of the window, and the X-direction may be the height direction of the window. The power-generating section of the power generation module 1 need only have at least one solar cell element and need not have a solar cell element string structure. Each submodule 100 only needs to be electrically connected to at least one other submodule, and the wiring structure may be selected as appropriate. In the illustrated example, the thickness, shape (size), and material of the plural submodules 100 constituting the power generation module 1 are all the same, but may be different. Furthermore, the sealing structure between the submodule 100 and the first substrate 11 and the second substrate 12, the structure of the filler, and the like may be changed as appropriate.

The shape, material, etc. of each component of the power generation module are not particularly limited. For example, the first substrate 11, the second substrate 12, or the base substrate 110 of the submodule 100 are not limited to glass substrates and may be transparent resin substrates such as acrylic. Furthermore, in the above embodiment, the photovoltaic layer PV containing a perovskite compound is used, but the photovoltaic layer PV may also be a layer containing other known photoelectric conversion materials, such as a thin-film silicon-based semiconductor layer of amorphous silicon or microcrystalline silicon, a compound semiconductor layer of CIS or CIGS, or an organic semiconductor layer.

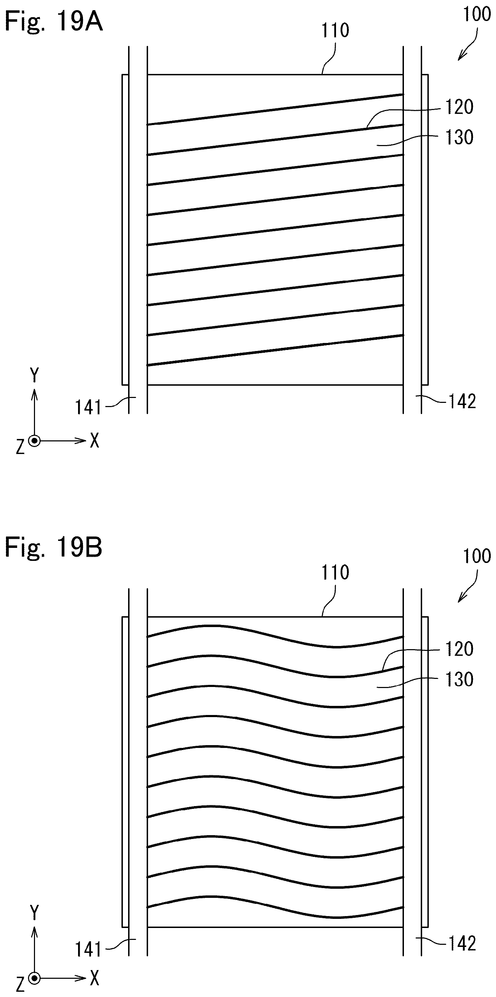

The configuration of the submodule 100 is not limited to the example shown in the figure. The plural strings 120 only need to extend from one end to the other end of the base substrate, and do not have to extend along the X-direction. For example, as illustrated in Fig. 19A, some or all of the strings 120 may extend obliquely with respect to the Y-direction. Alternatively, as illustrated in Fig. 19B, some or all of the strings 120 may extend in a curved line.

(Effect)

As described above, the power generation module 1 includes the plural submodules 100. The plural submodules 100 includes a first submodule 101 and a second submodule 102 that are arranged adjacent to each other in plan view seen along the first direction. Each of the plural submodules 100 includes the base substrate 110 having light-transmitting properties and a power-generating section located on a portion of a main surface 110s of the base substrate 110. The power-generating section includes at least a photovoltaic layer PV supported on the main surface 110s. In plan view, the area ratio of the power-generating section (power-generating section area ratio) to the main surface 110s in the first submodule 101 is smaller than the area ratio of the power-generating section to the main surface 110s in the second submodule 102.

The power generation module 1 includes two submodules 101 and 102 with different power-generating section area ratios, so that the function, design, etc. can be changed depending on the position, thereby increasing the degree of freedom in design.

More specifically, the larger the power-generating section area ratio of each submodule 100, the higher the power generation efficiency per unit area, but the lower the light transmittance. Therefore, by differentiating the power-generating section area ratios of the two submodules 101 and 102, it is possible to differentiate not only the power generation efficiency per unit area but also the light transmittance. This allows for design based on the intended use of the power generation module 1 (such as the building materials used and the environment in which it is used). Furthermore, the difference in light transmittance can be utilized to enhance the design quality.

Generally, a solar cell array is formed by arranging solar cells with the same structure (same power generation performance). In contrast, in this embodiment, a power generation module is formed by combining plural submodules with different power-generating section structures (power generation performance), thereby adding, for example, design features.

In this embodiment, the power-generating section itself, which has solar cell functionality, is used to achieve the desired design quality or light transmittance, eliminating the need for additional components. This makes it possible to provide a power generation module with a high level of design while minimizing the number of manufacturing steps and components.

The power generation module 1 further includes the first substrate 11 having light-transmitting properties and the second substrate 12 having light-transmitting properties. The second substrate 12 is disposed to face the first substrate 11 in the first direction (Z-direction). The plural submodules 100 are located between the first substrate 11 and the second substrate 12. The main surface 110s of the base substrate 110 of each submodule 100 is disposed to face the second substrate 12, for example.

According to the above configuration, the power generation module 1 has a configuration in which the plural submodules 100 are smaller than the first substrate 11 and the second substrate 12 and are arranged between the first substrate 11 and the second substrate 12, so that it can support various sizes of building materials through the number and arrangement of the submodules 100.

Furthermore, in the power generation module 1, the first substrate 11, the second substrate 12, and the base substrate 110 have light-transmitting properties, allowing light to pass through in the first direction of the power generation module 1. Accordingly, the power generation module 1 can be suitably applied to applications requiring high visible light transmittance, such as building material-integrated solar cells for building windows.

In each of the first submodule 101 and the second submodule 102, the power-generating section may include the plurality of strings 120 supported on the main surface 110s of the base substrate 110. Each of the plurality of strings 120 is a solar cell element string 120 having a structure in which the plurality of solar cell elements 150 are connected in series. In plan view seen along the first direction, each of the plurality of strings 120 extends from one end side to the other end side of the base substrate 110. With the above configuration, in each of the submodules 101, 102, it is possible to design the transmittance and implement a desired design by changing the number, arrangement, etc. of the strings 120.

The first submodule and the second submodule may be adjacent to each other in the second direction in plan view, and each of the first submodule 101 and the second submodule 102 may further include the first wiring 141 arranged on one end side of the base substrate 110 and the second wiring 142 arranged on the other end side of the base substrate 110. In each of the first submodule 101 and the second submodule 102, the plural strings 120 may be arranged at a distance from each other in the second direction. Each of the plural strings 120 may extend from the first wiring 141 to the second wiring 142 in the third direction (X-direction) intersecting the second direction.

According to the above configuration, the plural strings 120 are connected in parallel in each of the submodules 101, 102. This reduces the influence on the power generation performance of the submodules of differences in power generation performance due to differences in string width, even when the strings 120 with different widths are formed (see the embodiment described later).

In at least one of the first submodule 101 and the second submodule 102, the plural strings 120 may be arranged at equal intervals in the second direction in plan view along the first direction. With the above configuration, in the photovoltaic film processing step for manufacturing the submodule, laser processing for forming the plural strings 120 can be performed with the processing conditions (irradiation width wL of the laser beam LB) set to a constant value.

The plural submodules 100 may further include the third submodule 103 located on the side of the second submodule 102 opposite to the first submodule 101 in the second direction. In plan view seen along the first direction, the area ratio of the power-generating section to the main surface 110s of the second submodule 102 may be smaller than the area ratio of the power-generating section to the main surface 110s of the third submodule 103. With this configuration, it is possible to change the light transmittance in the second direction in a module column including the submodules 101 to 103 (see line 90 in Fig. 27).

The plural submodules 100 may further include the fourth submodule 104. In plan view seen along the first direction, the fourth submodule 104 is disposed adjacent to the first submodule 101 in the third direction intersecting the second direction. In plan view seen along the first direction, the area ratio of the power-generating section to the main surface 110s of the fourth submodule 104 may be equal to the area ratio of the power-generating section to the main surface 110s of the first submodule 101.

The fourth submodule 104 need not be designed specifically for it, and may be the same as the first submodule 101. In this case, there is no need to design an area ratio specifically for the fourth submodule, and it is sufficient to arrange the same one as the first submodule 101. Furthermore, the strings 120 of the first submodule 101 and the fourth submodule 104 are arranged on the first substrate 11 so as to be substantially aligned in the X-direction. This makes it possible to make the transmittance constant in the X-direction. Furthermore, a sense of unity can be achieved in the design of the power generation module.

The above configuration makes it possible to maintain the light transmittance of the power generation module 1 constant in the third direction (X-direction). This allows for a unified design, particularly when the power generation module 1 is applied to a large-area building material. Furthermore, the current capacity of the first submodule 101 and the fourth submodule 104 can be made the same, which is particularly advantageous when these submodules are connected in series.

The first submodule 101 and the second submodule 102 may be connected in parallel. This allows for increased output current. Furthermore, compared to connecting the submodules 101 and 102 in series, the influence on the power generation performance of the power generation module 1 of differences in power generation performance due to differences in the power-generating section area ratio between the submodules 101 and 102 can be reduced.

The plural submodules 100 may form a solar cell array. For example, the power generation module 1 includes plural module columns Ra to Rc. Each module column includes at least the first submodule 101 and the second submodule 102, and extends in the second direction in plan view along the first direction. The plural module columns Ra to Rc are arranged in the third direction (X-direction) that intersects with the second direction, and are connected in series. With this configuration, the maximum current and maximum voltage of the power generation module 1 can be set within a desired range by combining series and parallel connections.

The photovoltaic layer PV may contain, for example, a perovskite compound. A photovoltaic film (perovskite film) containing a perovskite compound can be easily formed using coating techniques such as inkjet printing and spin coating. Furthermore, the perovskite film coated on the substrate can be easily processed into a fine shape, for example, by laser processing, further enhancing design flexibility. As a result, it is easy to form a precise gradation using the plural strings 120. Thus, using a layer containing a perovskite compound as the photovoltaic layer PV can further increase design freedom. Therefore, it can be more suitably applied to building-integrated solar cells.

According to this embodiment, the process of forming the submodule 100 includes the film formation step of forming the laminated film 170 including a photovoltaic film on the main surface 110s of the base substrate 110 having light-transmitting properties, and the film processing step of processing the laminated film 170 to form a power-generating section (e.g., plural strings 120) including a photovoltaic layer PV on a portion of the main surface 110s. The film processing step includes a laser processing process of removing a portion of the photovoltaic film from the main surface 110s by laser processing, so that the remaining portion of the photovoltaic film becomes the photovoltaic layer PV of the power-generating section. In the laser processing process, the area of the photovoltaic film removed relative to the area of the main surface 110s is made different between the first submodule 101 and the second submodule 102.

The above method allows for the manufacture of the power generation module 1 including two submodules 101, 102 with different removal area ratios of the photovoltaic film, i.e., different area ratios of the photovoltaic layer PV constituting the power-generating section. The light transmittance of the submodules 101 and 102 can vary depending on the removal area ratio of the photovoltaic film. Hence, the above method makes it possible to easily separately fabricate two submodules with different light transmittances by simply varying the laser processing conditions (e.g., the irradiation width wL and non-irradiation width wT of the laser beam LB). Furthermore, various designs can be implemented by varying the combination and arrangement of submodules with different light transmittances. For example, a power generation module can be manufactured by selecting and combining submodules according to customer requirements. Thus, a power generation module with excellent design quality can be manufactured while suppressing the increase in the number of manufacturing steps and manufacturing costs.

≪Second Embodiment≫

A power generation module according to a second embodiment of the present disclosure will be described below. The power generation module of this embodiment differs from the first embodiment in that, in at least one submodule, plural strings are arranged to form a gradation. The following description will mainly focus on the differences from the first embodiment, and will omit duplicate description as appropriate.

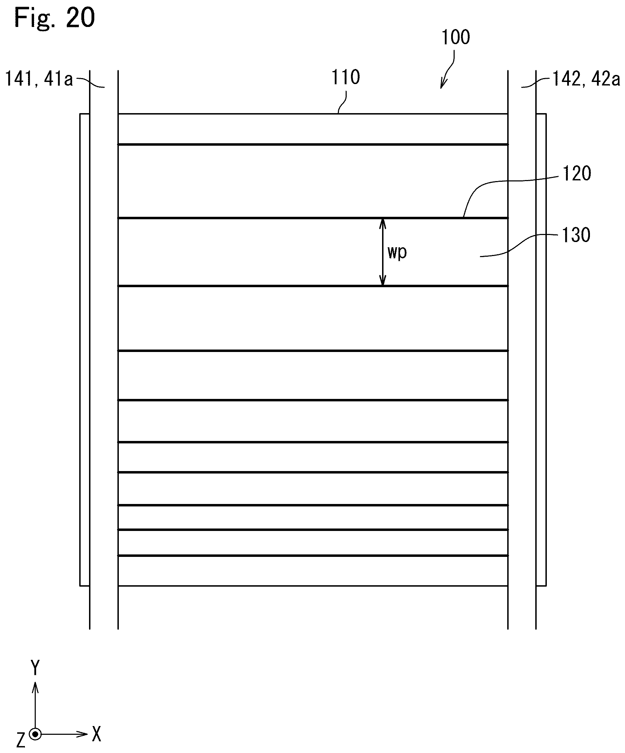

Fig. 20 is an enlarged top view showing one submodule in the second embodiment of the present disclosure.

As shown in Fig. 20, in the submodule 100, the plural strings 120 are arranged to form a gradation in which the inter-string region width wp gradually changes along the Y-direction. The widths (string widths) of the strings 120 may be the same or different. As will be described later, a gradation can also be formed by gradually changing the string width, string area ratio, etc. within one submodule.

According to this embodiment, by forming a gradation in the strings 120, it is possible to set the power-generating section area ratio of the submodule, and hence the light transmittance.

(Example of String Structure of First and Second Submodules)

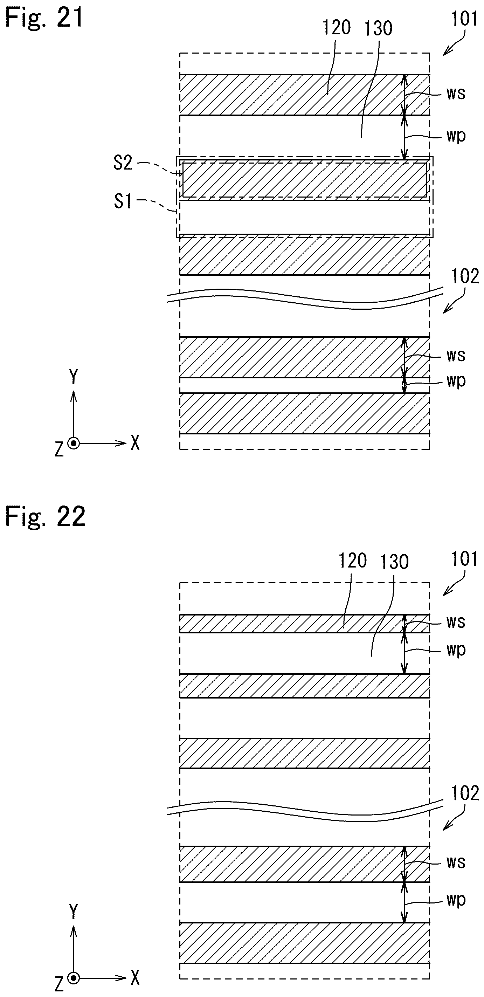

A gradation may be formed across two adjacent submodules. Design examples of the string structures will be described with reference to Figs. 21 to 23.

Figs. 21 to 23 are each a schematic enlarged top view of two adjacent submodules 101 and 102. In these figures, wiring is not shown.

In the example shown in Figs. 21 to 23, the power-generating section area ratio of the submodule 101 is smaller than the power-generating section area ratio of the submodule 102. In addition, a gradation is formed in which the string area ratio (S2/S1 shown in Fig. 21) gradually increases along the direction (-Y-direction) from the submodule 101 to the submodule 102.

The string structures shown in Figs. 21 to 23 are referred to as the fourth to sixth string structures, respectively. An overview of each structure is shown in Table 2. In Table 2, "gradual decrease (or increase)" means gradually decreasing (or increasing) in the -Y-direction.

[Table 2]

| | 4th String Structure | 5th String Structure | 6th String Structure |
|---|---|---|---|
| String Width ws | constant | gradual increase | gradual increase |

(continued)

|  | 4th String Structure | 5th String Structure | 6th String Structure |
|---|---|---|---|
| Inter-String Region Width wp | gradual decrease | constant | gradual decrease |
| Number N of Strings | N1<N2 | N1>N2 | N1=N2 |
| Array Pitch pt | gradual decrease | gradual increase | pt1=pt2 |

In the fourth string structure, the inter-string region width wp is set to gradually decrease in the second direction (here, the -Y-direction) from submodule 101 to submodule 102. Because the string width (width of the power-generating section) ws is constant, it is possible to make the power generation output of the plural strings 120 identical.

In the fifth string structure, the string width ws is set to gradually increase along the second direction (here, the -Y-direction) from the submodule 101 to the submodule 102. Because the inter-string region width wp is constant, this has the advantage that it is not necessary to change the processing conditions (laser irradiation width) for each string when processing the photovoltaic film. Furthermore, each submodule 101, 102 has a structure in which the plural strings 120 with different string widths (solar cell element widths) ws are connected in parallel. In this way, by intentionally combining plural strings (plural solar cell elements) with different power-generating section structures (power generation performance) to form a submodule, design features are added to the submodule.

In the sixth string structure, the string array pitch pt is constant from the submodule 101 to the submodule 102. By changing both the string width ws and the inter-string region width wp, the string area ratio is set to gradually increase along the second direction.

According to the fourth to sixth string structures, the strings 120 of the submodule 101 are arranged so that the string area ratio increases as they approach the submodule 102. On the other hand, the strings 120 of the submodule 102 are arranged so that the string area ratio increases as they move away from the submodule 101. The minimum string area ratio of the submodule 102 is greater than the maximum string area ratio of the submodule 101. This allows a gradation to be formed across the submodules 101 and 102.

(Method for Setting Light Transmittance of Submodule)

In this embodiment, the light transmittance of each submodule can also be set in a manner similar to that described with reference to Figs. 14 and 15. Note that, in order to form a gradation, the string width ws and/or the inter-string region width wp are set according to the position (the position in the second direction) on the main surface of the base substrate.

In the examples shown in Figs. 21 to 23, the string width, etc. is changed for each string, but the main surface 110s of the base substrate 110 may be divided into plural regions in the second direction, and the string width, inter-string region width, etc. may be made different for each region.

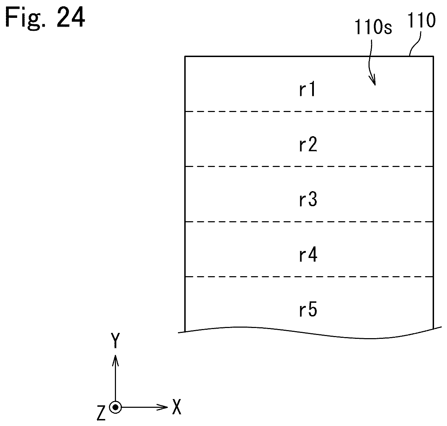

Table 3 shows a design example of a sixth string structure. In this example, as shown in Fig. 24, the main surface 110s of the base substrate 110 is divided into plural regions r1 to r5 in the second direction, and the string width ws and inter-string region width wp are set for each region. In Table 3, the widths ws and wp are shown as ratios to the array pitch pt.

[Table 3]

|  | String Width ws | Inter-String Region Width wp | Array Pitch pt |
|---|---|---|---|
| Region r1 | 0.9 | 0.1 | 1 |
| Region r2 | 0.8 | 0.2 | 1 |
| Region r3 | 0.7 | 0.3 | 1 |
| Region r4 | 0.6 | 0.4 | 1 |
| Region r5 | 0.5 | 0.5 | 1 |

(Module Column Gradation)

When the fourth to sixth string structures (Figs. 21 to 23) are applied to a module column having, for example, three or more submodules, a gradation in which the string area ratio changes in one direction can be formed in the module column (not only within each submodule but also between submodules). Therefore, each submodule has its own gradation, and plural (e.g., three) submodules as a whole can have a gradation that incorporates the individual gradations.

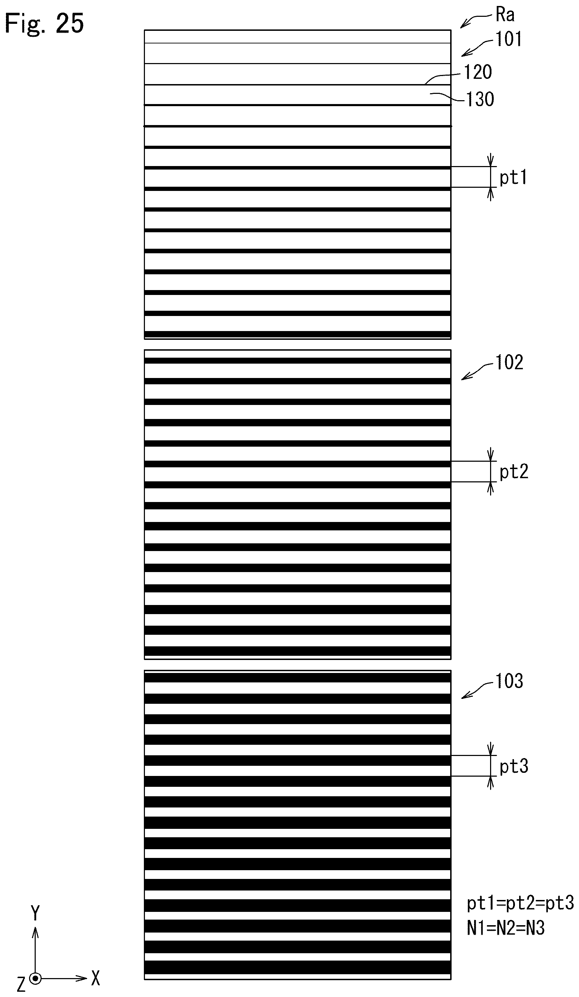

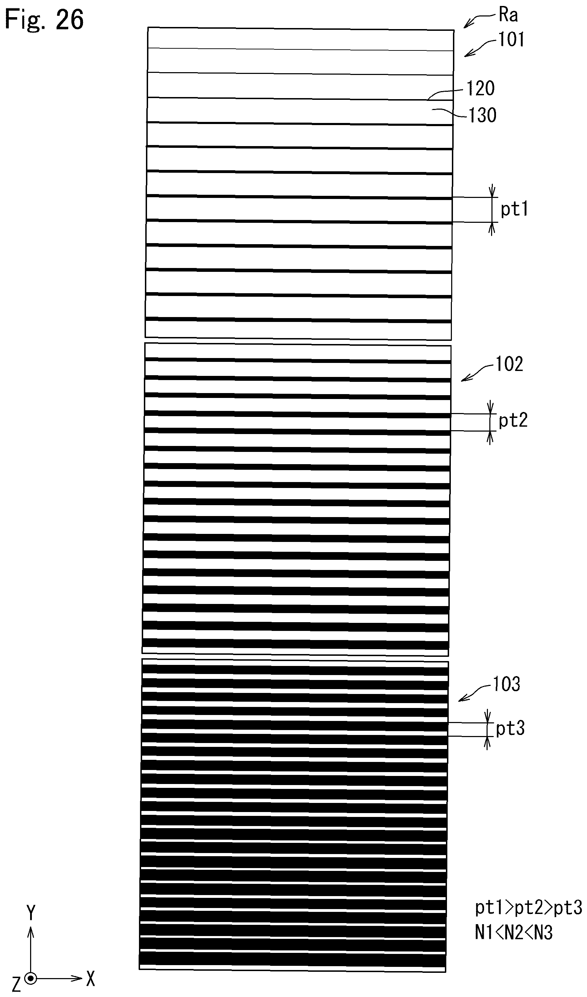

Figs. 25 and 26 are schematic top views illustrating an example of a module column gradation. These figures illustrate the module column Ra including the submodules 101 to 103. In the module column Ra, a gradation is formed from the top end of the submodule 101 to the bottom end of the submodule 103.

In the example shown in Fig. 25, the array pitches pt1, pt2, pt3 and the numbers N1, N2, N3 of the strings in the submodules 101 to 103 satisfy the following relationships:

$$pt1 = pt2 = pt3$$

$$N1 = N2 = N3$$

(here 15)

In the module column Ra, the string width ws gradually increases (here, in 45 steps) along the second direction (here, the -Y-direction). The inter-string region width wp gradually decreases along the second direction. This forms a gradation in which the string area ratio gradually increases along the second direction.

In the example shown in Fig. 25, the string area ratio varies regularly (or quasi-regularly) in the second direction across the module column Ra. Therefore, as shown schematically by line 91 in Fig. 27, the light transmittance can be smoothly increased across the plural submodules 101 to 103 in the module column Ra. For example, the amount of change in the string area ratio across two adjacent submodules is substantially the same as the amount of change in the string area ratio within each submodule. The string area across the two submodules may also vary with the same regularity as within each submodule. Note that in Fig. 27, the string width and spacing are assumed to be sufficiently small compared to the size of the base substrate, and the gradual change in the string area ratio at each pitch is represented approximately as a straight line.

In the module column Ra shown in Fig. 26, the array pitches pt1 to pt3 and the numbers N1 to N3 of the strings in the submodules 101 to 103 satisfy the following relationship.

$$pt1 > pt2 > pt3$$

$$N1 < N2 < N3$$

In each of the submodules 101 to 103, the strings 120 are arranged at equal pitches. The string width ws gradually increases along the second direction (here, the -Y-direction), and the inter-string region width wp gradually decreases along the second direction. This module column Ra can be said to be a configuration in which the string width is varied, for example, applied to the submodules 101 to 103 shown in Fig. 7.

In the example shown in Fig. 26, each of the submodules 101 to 103 has a gradation, and the string area ratio changes rapidly between adjacent submodules. For example, the change in string area ratio across two adjacent submodules is greater than the change in string area ratio within each submodule. Therefore, as shown schematically by a line 92 in Fig. 27, the change in light transmittance in the module column is greater between two adjacent submodules than within these two submodules.

Figs. 25 and 26 show only three submodules 101 to 103, but a module column having a gradation may be formed by four or more submodules. Furthermore, plural module columns having the same gradation structure may be arranged in the X-direction. Furthermore, the gradation of this embodiment may be formed in one region across plural submodules. For example, the gradation may be formed only in the lower portion of the first submodule and the upper portion of the second submodule in plan view.

(Method for Manufacturing Submodule)

The submodule with gradation can be manufactured by the same method as in the above embodiment, except for the film processing step of processing the photovoltaic film. Hereinafter, as for the film processing step in this embodiment, differences from the step described above with reference to Figs. 10A to 10C will be described, and similar description will be omitted as appropriate.

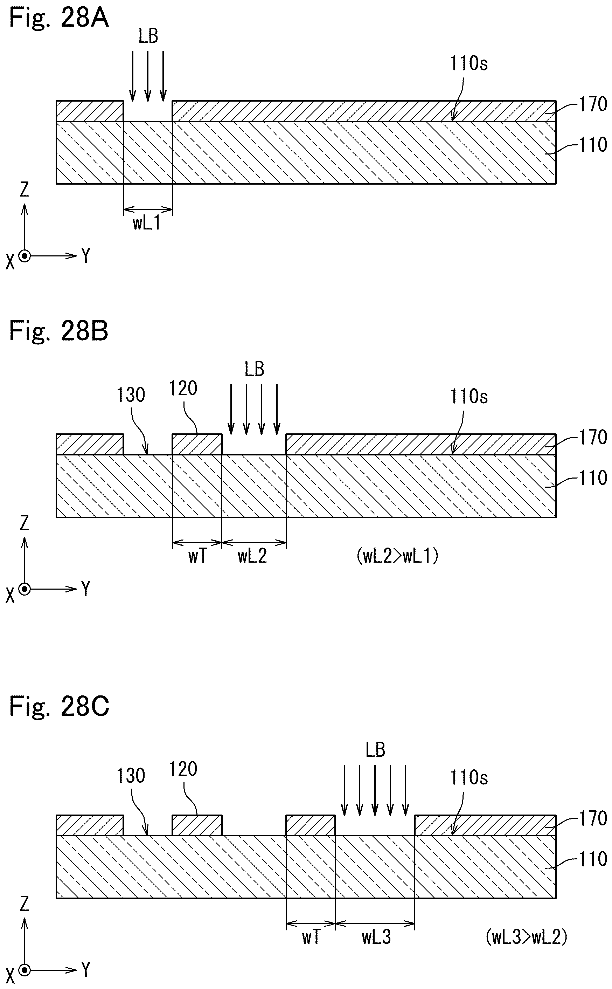

Figs. 28A to 28C are schematic process cross-sectional views illustrating a method for processing a laminated film including a photovoltaic film.

The method shown in Figs. 28A to 28C are applied to a configuration in which the width of the inter-string region is gradually changed (see Fig. 21). This method differs from the method shown in Figs. 10A to 10C in that the irradiation width (irradiation range) is set so that the width of the removed laminated film gradually increases (or decreases).

As shown in Fig. 28A, the laser beam LB is scanned in the X-direction, and the laminated film 170 is irradiated with the laser beam LB at an irradiation width wL1. This removes the irradiated portion of the laminated film 170. Next, as shown in Fig. 28B, the irradiation position of the laser beam LB is shifted in the Y-direction by a predetermined distance (non-irradiation width) wT, and the laminated film 170 is irradiated with the laser beam LB at an irradiation width wL2 (wL2 > wL1) that is larger than the irradiation width wL1. As shown in Fig. 28C, the laminated film 170 is processed by shifting the irradiation position at equal intervals in the Y-direction and changing the irradiation width. In this way, a gradation in which the spacing between the strings 120 gradually changes in the Y-direction is formed on the main surface 110s.

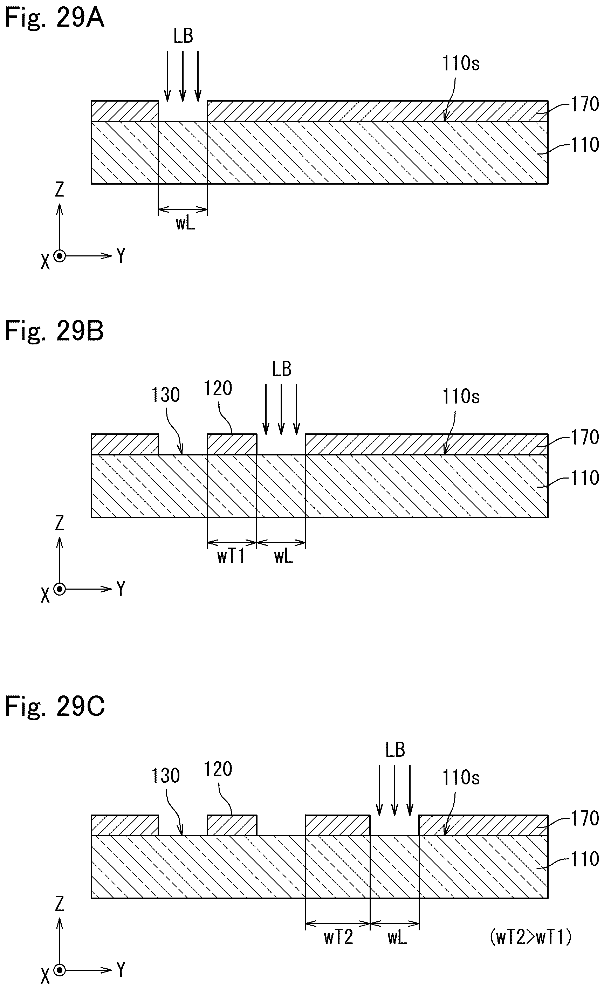

Figs. 29A to 29C are each a schematic process cross-sectional view illustrating another method for processing a laminated film including a photovoltaic film.

The method shown in Figs. 29A to 29C is applied to a configuration in which the string width is gradually changed (see Fig. 22). This method differs from the method shown in Figs. 10A to 10C in that the laminated film is processed while varying the moving distance (non-irradiation width) of the laser head.

Specifically, as shown in Fig. 29A, first, laser beam LB is scanned in the X-direction to irradiate the laminated film 170 with the laser beam LB over an irradiation width wL, thereby removing the irradiated portion of the laminated film 170. Next, as shown in Fig. 29B, the irradiation position of the laser beam LB is shifted in the Y-direction by a predetermined distance (non-irradiation width) wT1, and the laminated film 170 is irradiated with the laser. Subsequently, as shown in Fig. 29C, the irradiation position of the laser beam LB is shifted in the Y-direction by a non-irradiation width wT2 that is larger than the non-irradiation width wT1, and laser irradiation is performed. This forms a gradation in which the width of the string 120 gradually changes.

<Effects, etc.>

In this embodiment, in each of the plural submodules 100, the main surface 110s of the base substrate 110 includes plural inter-string regions 130 located between two adjacent strings 120. At least the string 120 of the first submodule 101 may be configured, for example, as follows.

The plural strings 120 are arranged at distances from one another in the second direction so that at least one of the string width ws, the inter-string region width wp, and the string area ratio S2/S1 forms a gradation that gradually changes along the second direction. In plan view along the first direction, the string width ws is the width of each string 120 along the second direction. The inter-string region width wp is the width of each inter-string region 130 along the second direction. The string area ratio S2/S1 is the ratio of the area S2 of each string 120 to the total area S1 of each string 120 and the inter-string regions 130 adjacent to that string 120 in the second direction, in plan view seen along the first direction.

According to the above configuration, the first submodule 101 has a gradation along the second direction (Y-direction), which further enhances the design quality of the power generation module 1.

The plural submodules 100 may further include the third submodule 103 located on the side of the second submodule 102 opposite to the first submodule 101 in the second direction (Y-direction). The strings 120 of these submodules 101 to 103 may be configured, for example, as follows:

In each of the submodules 101 to 103, the plural strings 120 are arranged such that at least one of the string width ws, the inter-string region width wp, and the string area ratio S2/S1 gradually increases along the second direction. A gradation is formed from the submodule 101 across the submodule 102 to the submodule 103, in which at least one of the string width ws and the inter-string region width wp gradually increases along the second direction.

According to the above configuration, a gradation is formed in each of the submodules 101 to 103, and a gradation is also formed across the submodules 101 to 103. This allows the design quality of the power generation module 1 to be further enhanced.

The plural submodules 100 may further include the fourth submodule 104. The fourth submodule 104 is arranged adjacent to the first submodule 101 in the third direction (X-direction) intersecting the second direction (Y-direction) in plan view seen from the first direction (Z-direction). The plural strings 120 of the fourth submodule 104 may be arranged to form a gradation similar to that of the first submodule 101. This configuration makes it possible to form a gradation with a sense of unity over a wider range.

Furthermore, in this embodiment, the gradation is formed by laser processing the photovoltaic film. Thus, by changing the laser processing conditions (irradiation width, non-irradiation width), it is possible to separately fabricate submodules with a variety of gradations.

≪Third Embodiment≫

(Findings Made by the Inventors)

The present inventors have more thoroughly studied the structure of a power generation module that can be integrated with building materials (for example, window glass) of various sizes, and have come to the following findings.

For example, JP10-299353A discloses a configuration in which a solar cell panel consisting of a plurality of solar cells is disposed between two panes of glass as a building material (for example, window glass).

According to the conventional configuration disclosed in JP10-299353A, depending on the size of the window glass, it may be difficult to arrange solar cell panels over the entire surface of the window glass. As a result, in a plan view, solar cell panels may be arranged only on a portion of the window glass, resulting in areas around the window glass where no solar cell panels are arranged. In such cases, a step (e.g., a step equivalent to the thickness of the solar cell) may occur between two panes of glass between the area where the solar cell panels are arranged and the area where they are not arranged (referred to as the "non-power-generating area") between the two panes of glass. In other words, a gap may occur between the two panes of glass in the non-power-generating area. As a result, air is likely to remain between the panes during lamination, potentially creating air bubbles. These air bubbles may significantly affect the appearance. Furthermore, the air bubbles may affect the photovoltaic layer.

In contrast, in the above-described embodiment, as shown in Fig. 13C, a filler is placed between the submodule and the two substrates, and the filler is caused to fill the gaps by lamination, thereby suppressing the generation of air bubbles. By appropriately selecting the amount of filler and the lamination conditions, it is possible to suppress the generation of air bubbles.

However, there are manufacturing constraints on the size of the submodules. For this reason, depending on the size of the window glass, the area where the submodules cannot be densely arranged (non-power-generating region) may become large. This may make air bubbles more likely to occur. It may also increase the amount of filler used.

Thus, the inventors devised a configuration in which non-power-generating members electrically isolated from the submodules are arranged in the non-power-generating regions between the substrates where no submodules are arranged. This reduces the step, making it possible to more reliably suppress the generation of bubbles during lamination. Furthermore, it is possible to suppress the generation of bubbles while reducing the amount of filler used.

A power generation module according to a third embodiment of the present disclosure will be described hereinbelow. The power generation module of this embodiment differs from the previous embodiments in that it includes a non-power-generating section that is not electrically connected to any of the submodules and is located within a space surrounded by a first substrate, a second substrate, and a sealing member. The following will mainly describe the differences from the previous embodiments, and will omit duplicate description as appropriate.

(Structure of Power Generation Module of Third Embodiment)

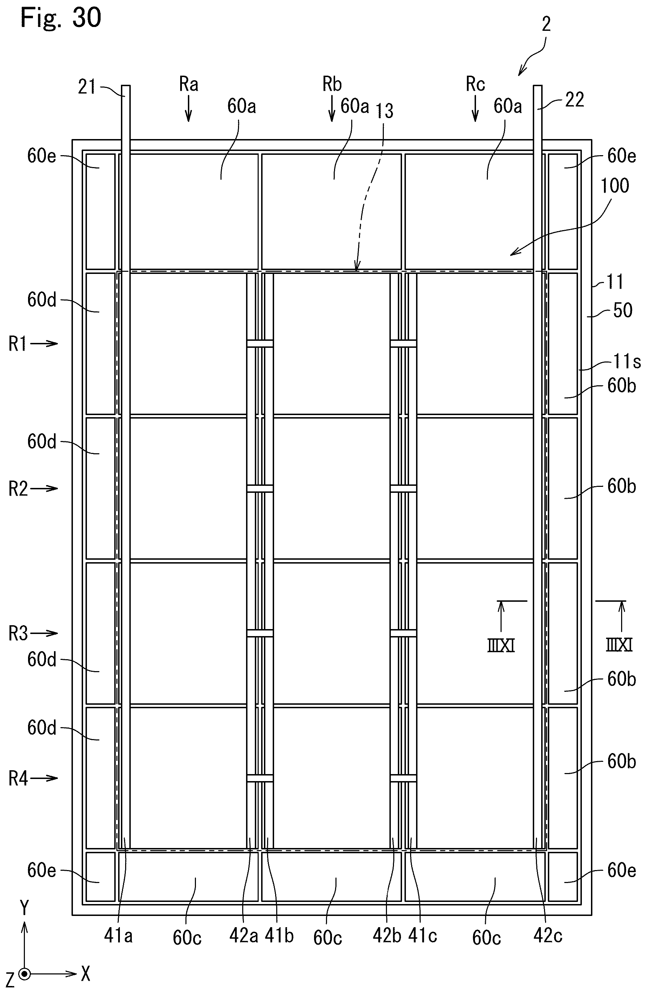

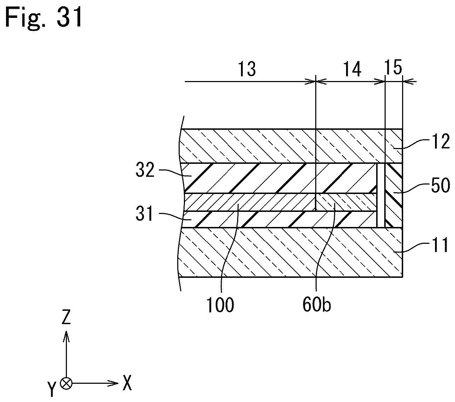

Fig. 30 is a top view showing a power generation module according to a third embodiment of the present disclosure, and Fig. 31 is a schematic cross-sectional view of the power generation module of Fig. 30 taken along line IIIXI-IIIXI.

A power generation module 2 includes the first substrate 11, the second substrate 12, the plurality of submodules 100, a plurality of non-power-generating members 60a to 60e, the first filler 31, the second filler 32, and the sealing member 50.

In plan view seen from the Z-direction, the sealing member 50 is positioned outside the region in which the submodule 100 is disposed. The non-power-generating members 60a to 60e are disposed between the sealing member 50 and the central region 13. In this specification, as shown in Fig. 31, the region 13 on the first surface 11s of the first substrate 11 where the submodule 100 is located is referred to as the "central region" or "first region." Furthermore, the region 15 on the first surface 11s where the sealing member 50 is located is referred to as the "sealing region" or "third region." Furthermore, the region 14 on the first surface 11s located between the central region and the sealing region is referred to as the "peripheral region" or "second region." The non-power-generating members 60a to 60e are disposed in the peripheral region 14.

In the example shown in Fig. 30, in plan view seen from the Z-direction, the sealing member 50 is disposed so as to surround the central region 13. Therefore, the non-power-generating members 60a to 60e and the submodule 100 are disposed within the space defined by the first substrate 11, the second substrate 12, and the sealing member 50. The non-power-generating members 60a to 60e are arranged inside the sealing member 50 so as to surround the central region 13.

In plan view seen from the Z-direction, the non-power-generating member need not surround the central region 13. It will suffice as long as at least one non-power-generating member is disposed between any one of the submodules 100 and the sealing member 50.

Each of the non-power-generating members 60a to 60e is a member electrically isolated from all of the submodules 100. Depending on the intended use of the power generation module 2, for example, when the power generation module 2 is used as a building material such as a window, the non-power-generating members 60a to 60e may have light-transmitting properties.

In the example shown in Fig. 30, in plan view seen from the Z-direction, the plurality of (three in this example) non-power-generating members 60a are arranged along the X-direction in an upper portion of the peripheral region 14 located above (on the +Y side of) the central region 13. A plurality of (four in this example) non-power-generating members 60b are arranged along the Y-direction in a right portion of the peripheral region 14 located to the right (on the +X side of) the central region 13. A plurality of (three in this example) non-power-generating members 60c are arranged along the X-direction in a lower portion of the peripheral region 14 located below (on the -Y side of) the central region 13. A plurality of (four in this example) non-power-generating members 60d are arranged along the Y-direction in a left portion of the peripheral region 14 located to the left (on the -X side of) the central region 13. Each of the non-power-generating members 60a, 60c is arranged adjacent to a corresponding one of the submodules 100 in the Y-direction. Each of the non-power-generating members 60b, 60d is arranged adjacent to a corresponding one of the submodules 100 in the X-direction. Furthermore, a plurality of (four in this example) non-power-generating members 60e are arranged at corner portions located at the four corners of the first substrate 11 in the peripheral region 14.

The size and shape of each part of the peripheral area 14 are not limited to the example shown in the drawing. The size and shape of each part of the peripheral area 14 may vary depending on the size and shape of the building materials (e.g., windows) to which the power generation modules 2 are applied, the size and arrangement of the power generation modules 2, and the like.

As shown in Fig. 31, the first filler 31 is located between the first substrate 11 and the submodule 100 and the non-power-generating members 60a to 60e. The second filler 32 is located between the second substrate 12 and each of the submodules 100 and non-power-generating members 60a to 60e. At least a portion of the upper surfaces of the non-power-generating members 60a to 60e is in contact with the second filler 32.

In the example shown in Fig. 31, the bottom surfaces of the non-power-generating members 60a to 60e (non-power-generating member 60b in Fig. 2) are in contact with the first filler 31, and the upper surfaces are in contact with the second filler 32. In the second region 14, the gap between the first substrate 11 and the second substrate 12 is filled with the fillers 31 and 32 and the non-power-generating member 60b. In this example, a gap (space) is formed between the non-power-generating member 60b and the sealing member 50, but this gap may also be filled by the fillers 31 and 32 flowing around.

The thickness (thickness in the Z-direction) of each of the non-power-generating members 60a to 60e is, for example, the same as the thickness of the submodule 100. Here, "the same thickness (approximately the same thickness)" means that the thicknesses are designed to be the same, and may include manufacturing tolerances. The upper surfaces of the non-power-generating members 60a to 60e and the upper surface of the submodule 100 may be flush with each other.

In the example shown in Fig. 30, the area of each of the non-power-generating members 60a to 60d is, for example, smaller than the area of the submodule 100. Furthermore, the non-power-generating members 60a and 60c adjacent to the submodule 100 in the Y-direction are arranged at the same pitch in the X-direction as the submodule 100. The widths of the non-power-generating members 60a and 60c in the X-direction are the same as the width of the submodule 100 in the X-direction. Similarly, the non-power-generating members 60b and 60d adjacent to the submodule 100 in the X-direction are arranged at the same pitch in the Y-direction as the submodule 100. The widths of the non-power-generating members 60b and 60d in the Y-direction are the same as the width of the submodule 100 in the Y-direction. This allows each of the non-power-generating members 60a and 60c to be arranged in the corresponding module column. Furthermore, each of the non-power-generating members 60b and 60d can be arranged in the corresponding module row. This allows a unified design to be achieved between the central region 13 and the peripheral region 14.

(Structure of Non-Power-Generating Member)

The non-power-generating members 60a to 60e are not particularly limited, but may be made of the same material as that of the first substrate 11, the second substrate 12, or the base substrate of the submodule 100. The non-power-generating members 60a to 60e may be, for example, glass members or transparent resin members. Alternatively, the non-power-generating members 60a to 60e may have the same structure as the submodule 100.

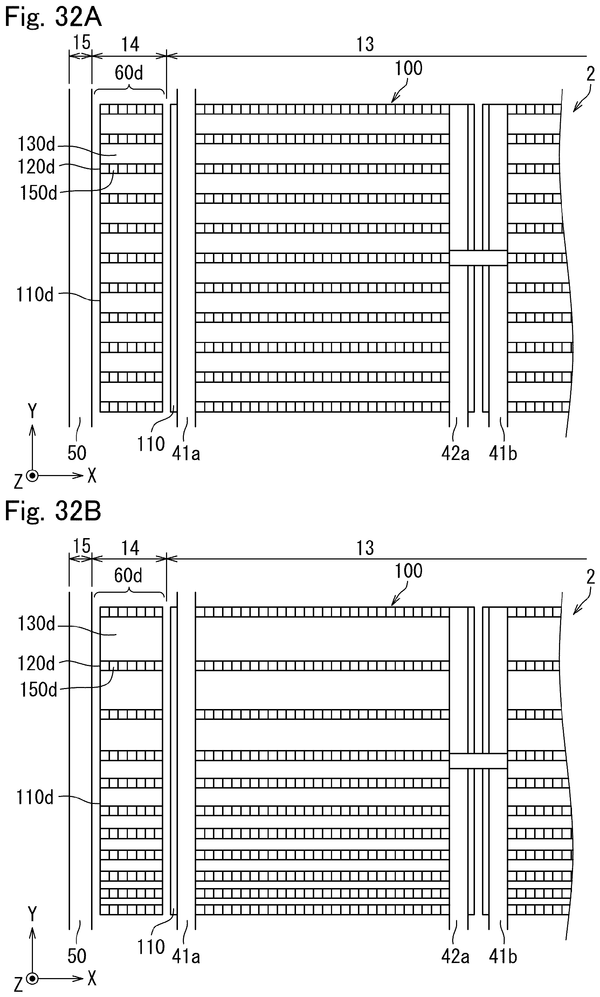

Hereinafter, referring to Fig. 32A, an example will be described where the non-power-generating members 60a to 60e have a structure similar to that of the submodule 100. Fig. 32A is an enlarged top view showing a portion of the power generation module of Fig. 30. Fig. 32A shows one submodule 100 in the leftmost module row and one non-power-generating member 60d located in the left portion of the peripheral region 14.

As shown in Fig. 32A, the non-power-generating member 60d is disposed adjacent in the X-direction to one of the submodules 100 that constitutes the leftmost module column Ra.

In the submodule 100, plural strings 120 are arranged at equal pitches in the Y-direction (see Fig. 4, etc.). Each string 120 has a layered structure including a pair of transparent electrodes and a photovoltaic layer. The string 120 has a structure in which power generating elements are connected in series in the horizontal direction (X-direction).

The non-power-generating member 60d also has a configuration similar to that of the submodule 100. That is, the non-power-generating member 60d includes a base substrate 110d and a plurality of dummy strings 120d located on the main surface of the base substrate 110d. The dummy strings 120d include a photovoltaic layer. Each of the dummy strings 120d may have a stacked structure similar to that of the strings 120 of the submodule 100, for example, a structure in which plural dummy elements 150d are connected in series (see Figs. 6A and 6B). The photovoltaic layer of the dummy string 120d includes, for example, the same photoconversion material as that of the photovoltaic layer of the string 120, such as a perovskite compound. The dummy string 120d also includes a photovoltaic layer and performs photoelectric conversion, but does not extract electricity. For this reason, the member 60d including the dummy strings 120d is defined herein as a "non-power-generating member."

The plurality of dummy strings 120d are electrically isolated from one another and from the strings 120 of all of the submodules 100 that make up the power generation module 2.

In plan view seen along the Z-direction, each dummy string 120d and a corresponding string 120 of a submodule 100 adjacent in the X-direction are aligned in the vertical direction (Y-direction). That is, each dummy string 120d is arranged in a straight line with its corresponding string 120. In the example shown in Fig. 32A, the widths of the dummy string 120d and the strings 120 in the Y-direction are the same. Furthermore, the dummy strings 120d are arranged at a pitch with respect to the strings 120 in the Y-direction.

In this way, the submodule 100 and the non-power-generating member 60d are configured to have the same photovoltaic layer area ratio in plan view along the Z-direction. In this specification, the "photovoltaic layer area ratio" refers to the area ratio of the portion where the photovoltaic layer is present relative to the main surface of the base substrate 110, 110d in each submodule or each non-power-generating member. The area of the portion where the photovoltaic layer is present is, for example, the total area of the string 120 or the dummy string 120 in plan view along the Z-direction. Because the area of one string 120 is roughly equal to the total area of the plural semiconductor layers 153 (Fig. 6A) included in that string 120, the area of the string 120 can be considered here as the area of the portion where the photovoltaic layer is present.

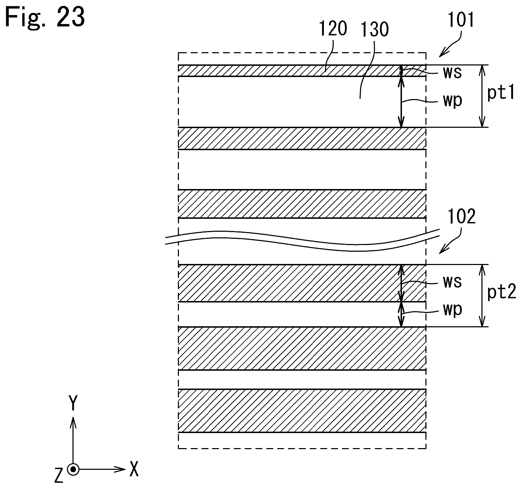

Fig. 32B is an enlarged top view showing another example of the submodule and non-power-generating member. In the example shown in Fig. 32B, the strings 120 of the submodule 100 are arranged to form a gradation in which the width of the inter-string region gradually changes in the Y-direction. The dummy strings 120d of the non-power-generating member 60d are also arranged to form a gradation similar to that of the submodule 100. In plan view seen from the Z-direction, each dummy string 120d and its corresponding string 120 are aligned in the vertical direction (Y-direction). Although not shown, the strings 120 and the dummy strings 120d may form a gradation using other string structures, such as a structure in which the string width or string area ratio gradually changes along the Y-direction (see Figs. 22 and 23).

In this way, since the submodule 100 and the non-power-generating member 60d have the same string structure, it is possible to form a gradation that spans from the central region 13 to the peripheral region 14. As a result, the design quality can be further enhanced.

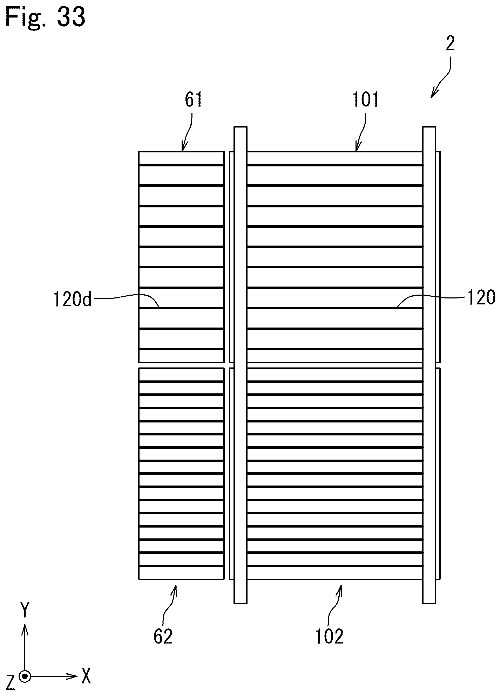

Fig. 33 is an enlarged top view showing another example of submodules and non-power-generating members. In the example shown in Fig. 33, the photovoltaic layer area ratios (power-generating section area ratios) of the submodules 101, 102 adjacent to each other in the Y-direction are different from each other. The non-power-generating member 60d includes a first member 61 adjacent to the submodule 101 in the X-direction and a second member 62 adjacent to the submodule 102 in the X-direction. The first member 61 has the same photovoltaic layer area ratio as the submodule 101, and the second member 62 has the same photovoltaic layer area ratio as the submodule 102. In this example, the submodules 101, 102 and the non-power-generating members 61 and 62 have the first string structure shown in Fig. 16. Note that, although not shown, the string 120 and the dummy string 120d may have other string structures, for example, those described in Figs. 17, 18, and 21 to 23 (see Figs. 22 and 23).

Here, the dummy string 120d of the member 61 and the string 120 of the submodule 101 are aligned in the X-direction. Similarly, the dummy string 120d of the member 62 and the string 120 of the submodule 102 are aligned in the X-direction.

The above describes the structure of the non-power-generating member 60d located on the left side of the central region 13 as an example, but the non-power-generating members 60a, 60b, 60c located on the upper, right, and lower sides of the central region 13 may also each have a string structure similar to that of the adjacent submodules 100.

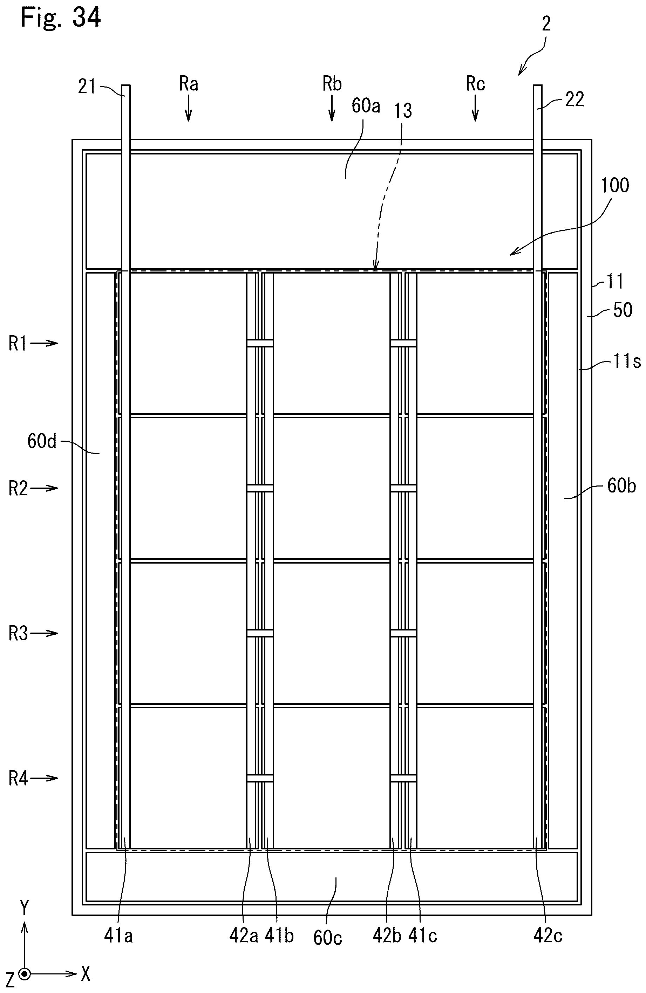

Fig. 34 is a top view showing another example of the power generation module of the third embodiment. In the example shown in Fig. 34, non-power-generating members 60a to 60d are disposed in each of the upper, lower, right, and left portions of the peripheral region 14. Each of the non-power-generating members 60a to 60d extends in the Y or X-direction so as to be adjacent to two or more submodules 100. This is advantageous in that precise alignment of each non-power-generating member with the submodule is not required. Furthermore, the number of boundary portions between two adjacent non-power-generating members can be reduced, making it less likely for air to enter the boundary portions. This can further suppress the impact of air on the photovoltaic layer.

In the example shown in Fig. 34, the width in the X-direction of each of the non-power-generating members 60a, 60c is greater than the width in the X-direction of the submodule 100 adjacent to that non-power-generating member. The length in the Y-direction of each of the non-power-generating members 60b, 60d is greater than the width in the Y-direction of the submodule 100 adjacent to that non-power-generating member. The area of each of the non-power-generating members 60a to 60d may be greater than the area of the submodule 100.

(Method for Manufacturing Non-Power-Generating Member)

The non-power-generating members 60a to 60e are manufactured in the same manner as the submodule 100. However, unlike the submodule 100, wiring need not be formed.

First, a laminated film including a photovoltaic film is formed on the base substrate 110d (film formation process, see Figs. 9A and 9B). Next, the laminated film is processed to form a laminated structure (dummy strings 120d) including a photovoltaic layer on a portion of the main surface of the base substrate 110d (film processing step). In the film processing step, the photovoltaic film can be processed by the first laser processing step and the second laser processing step (see Figs. 9C to 9D, 10A to 10C, 28A to 28C, and 29A to 29C). In this manner, a submodule structure is obtained in which dummy strings 120d including a photovoltaic layer are formed on the base substrate 110.

Next, the submodule structure is cut in a direction intersecting (here, orthogonal to) the main surface of the base substrate 110d to obtain non-power-generating members of the desired size. Depending on the size of the non-power-generating members, two or more non-power-generating members may be formed from one submodule structure. Note that the base substrate 110d of the same size as the non-power-generating members to be formed may be prepared and used in the film formation step and film processing step. In this case, the cutting step is not necessary.

The photovoltaic layers of the submodule 100 and the non-power-generating members 60a to 60e may be formed using the same material and under the same film-forming conditions. This makes the thickness of the photovoltaic layer of the submodule 100 the same as the thickness of the photovoltaic layer of the non-power-generating members 60a to 60e. Hence, the light transmittance of the non-power-generating members and the submodule can be adjusted based on the relationship between common light transmittance and photovoltaic layer area ratio (see Fig. 14).

In this embodiment, when manufacturing a non-power-generating member and a submodule having the same photovoltaic layer area ratio, such as the first member 61 and the first submodule 101 shown in Fig. 33, the photovoltaic film is removed under the same processing conditions (first processing conditions) in the film processing step. The processing conditions include laser irradiation conditions such as the irradiation width and the non-irradiation width. Similarly, when manufacturing the second member 62 and the second submodule 102 shown in Fig. 33, the photovoltaic film is removed under second processing conditions different from the first processing conditions in the film processing step. This allows the photovoltaic layer area ratio of the first member 61 and the first submodule 101 to be smaller than the photovoltaic layer area ratio of the second member 62 and the second submodule 102. In this way, by varying the processing conditions in the film processing step, submodules and non-power-generating members having different photovoltaic layer area ratios can be separately fabricated.

(Method for Manufacturing Power Generation Module)

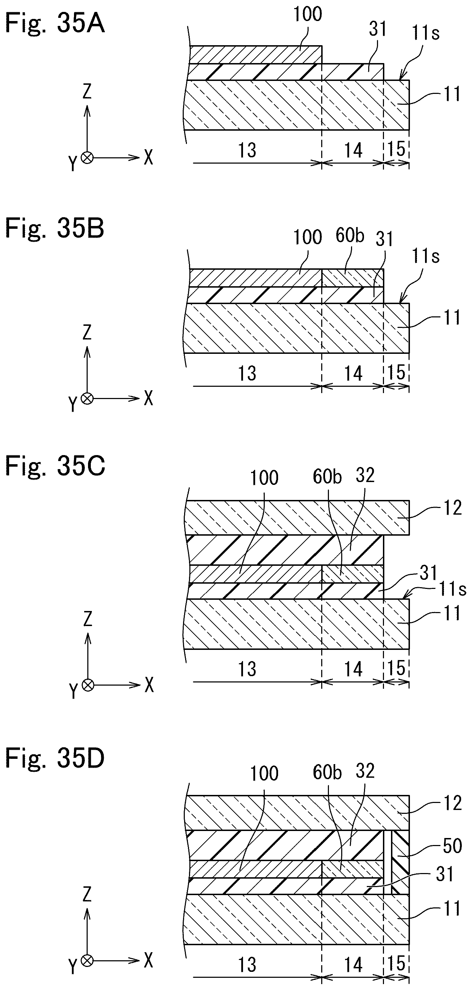

Next, a method for manufacturing the power generation module 2 using the non-power-generating members and submodules manufactured by the above-described method will be described with reference to Figs. 35A to 35D.

Figs. 35A to 35D are schematic process cross-sectional views illustrating a method for manufacturing the power generation module of Fig. 30. In the following description, descriptions similar to those in Figs. 13A to 13C will be omitted as appropriate.

First, as shown in Fig. 35A, the first filler 31 is placed on first surface 11s, which is the main surface of first substrate 11, and the plural submodules 100 are arranged on the first filler 31 (submodule arrangement step). The placement method is similar to the method described above with reference to Figs. 12A and 12B. Here, the plural submodules 100 are arranged in a planar manner in the central region 13 of the first surface 11s.

Next, as shown in Fig. 35B, the non-power-generating members 60a to 60e (non-power-generating member 60b in the cross section shown) are arranged in the peripheral region 14 located outside the central region 13 of the first surface 11s (non-power-generating member arrangement step). Each of the non-power-generating members 60a to 60e is electrically isolated from any of the submodules 100. The non-power-generating member arrangement step may be performed before the submodule arrangement step.

Subsequently, as shown in Fig. 35C, the second filler 32 is arranged above the submodule 100 and the non-power-generating members 60a to 60e (filler arrangement step). Then, the second substrate 12 is disposed on top of the second filler 32 so as to face the first substrate 11. The second filler 32 may be, for example, a filler sheet containing polyolefin. The second filler 32 is placed so as to be in contact with at least a portion of the upper surfaces of the non-power-generating members 60a to 60e.

Then, as shown in Fig. 35D, the first substrate 11 and the second substrate 12 are bonded together under reduced pressure. After this, the sealing member 50 is disposed in a sealing region 15 (in this example, the peripheral edge portion of the first substrate 11) located outside the peripheral region 14 on the first surface 11s to seal the space between the first substrate 11 and the second substrate 12. In this manner, the power generation module 2 is manufactured.

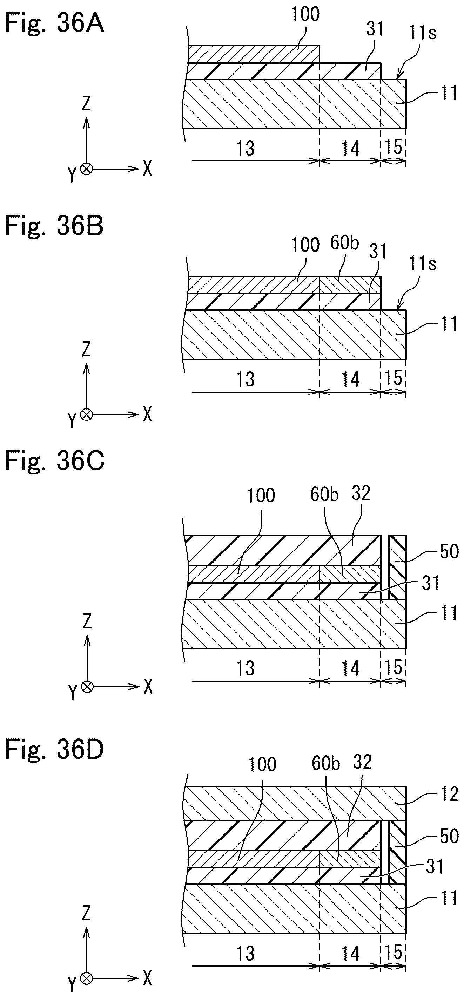

Figs. 36A to 36D are schematic process cross-sectional views illustrating another method for manufacturing the power generation module of Fig. 30. As shown in Figs. 36C and 36D, after the sealing member 50 is disposed on the first substrate 11, the second substrate 12 is disposed above the submodule 100, the non-power-generating members 60a to 60e, and the sealing member 50, and the first substrate 11 and second substrate 12 are bonded together.

The structure of the power generation module of this embodiment is not limited to the structure shown in Figs. 30 to 34. In the power generation module 2 described above, the non-power-generating members have light-transmitting properties, but they may not have light-transmitting properties. In the example described above, plural non-power-generating members are disposed between the substrates, but only a single non-power-generating member may be disposed. The non-power-generating member may be, for example, a frame-shaped member corresponding to the peripheral region 14. Although wiring connecting strings is not required in the non-power-generating members, dummy wiring (wiring not connected to the first wiring and the second wiring) may be formed in the non-power-generating members located in the upper or lower portion of the peripheral region 14 for appearance reasons. Furthermore, the first filler may not be disposed between the submodule and the non-power-generating members and the first substrate. Furthermore, for example, the power generation module may include only a single submodule. Even in this case, the same effect (suppressing generation of air bubbles) can be achieved by disposing a non-power-generating member.

(Effect)

The method for manufacturing the power generation module 2 of this embodiment includes the submodule arrangement step of arranging the submodule (solar cell submodule) 100 in the first region 13 of the first surface 11s of the first substrate 11; the non-power-generating member arrangement step of arranging the non-power-generating members 60a to 60e electrically isolated from the submodule 100 in a second region 14 located on the first surface 11s outside the first region 13; the filler arrangement step of arranging the filler 32 above the submodule 100 and the non-power-generating members 60a to 60e so as to be in contact with at least a portion of the upper surfaces of the non-power-generating members 60a to 60e; and the bonding step of arranging the second substrate 12 having light-transmitting properties on the filler 32 so as to face the first substrate 11, and bonding the first substrate 11 and the second substrate 12 together with the submodule 100 and the non-power-generating members 60a to 60e sandwiched therebetween using the sealing member 50 located in the third region 15 located on the first surface 11s outside the second region 14.

In the above method, on the first surface 11s, the non-power-generating members 60a to 60e and the filler 32 are arranged in the second region (peripheral region) 14 that is outside the submodule 100, and then the lamination process is performed. This reduces the step (gap) that occurs between the portion the submodules 100 are arranged and the portion where the submodules 100 are not arranged. Therefore, during the lamination step (e.g., lamination), air is less likely to remain in the step, making it less likely for bubbles to form. As a result, the impact of bubbles on the appearance can be reduced. Furthermore, the impact of bubbles (air) on the photovoltaic layer within the submodule 100 can be reduced.

Furthermore, by arranging the non-power-generating members 60a to 60e in the peripheral region 14, the amount of filler used can be suppressed compared to when air bubbles are reduced by utilizing the filler's wraparound (Fig. 13C).

Furthermore, with the above method, even if the size of the building material (e.g., a window) makes it difficult to densely arrange the submodules 100 over the entire surface of the window, two substrates (window glass) can be bonded together while suppressing the generation of air bubbles. It is thus possible to provide a highly versatile power generation module 2 that can be used irrespective of the size of the building material.

The non-power-generating members 60a to 60e may have the same thickness as the submodule 100. This configuration can more effectively reduce the step (gap) that occurs between the area where the submodule is arranged and the area where the submodule is not arranged. As an example, the upper surface of the submodule 100 arranged on the first substrate 11 can be made flush with the upper surfaces of the non-power-generating members 60a to 60e. Furthermore, even if the peripheral area 14 is large, it is easy to maintain a constant distance between the first substrate 11 and the second substrate 12.

In the non-power-generating member arrangement step, the plural non-power-generating members 60a to 60e may be arranged side by side in the second region 14 (Fig. 31). This configuration makes it easy to densely arrange the non-power-generating members 60a to 60e over the peripheral region 14, irrespective of the size or shape of the peripheral region 14. This makes it possible to more effectively suppress the generation of air bubbles. Furthermore, by arranging plural non-power-generating members at the same pitch as the submodules 100, the boundary portion between the central region 13 and the peripheral region 14 can be made less visible.

The non-power-generating members 60a to 60e may be made of the same material as the first substrate 11 or the second substrate 12. This allows the light transmittance of the portions where the non-power-generating members 60a to 60e are arranged to be equal to that of the other portions. Furthermore, since the thermal expansion coefficient of the non-power-generating members can be made equal to that of the first substrate 11 or the second substrate 12, deformation (warping) and stress caused by heat during lamination, for example, can be suppressed.

The step of forming the non-power-generating members 60a to 60e may include a film formation step and a film processing step similar to the submodule formation step of forming the submodule 100. The film formation step includes a step of forming a photovoltaic film by coating. The film processing step removes a portion of the photovoltaic film from the main surface by laser processing.

According to the above method, the submodule 100 and the non-power-generating members 60a to 60e can be manufactured using a common step. Furthermore, the light transmittance of the submodule 100 and the non-power-generating members 60a to 60e can be adjusted by, for example, adjusting the total area of the photovoltaic film removed in the film processing step. Therefore, the light transmittance can be adjusted across the central region 13 and the peripheral region 14. Furthermore, a desired design (e.g., gradation) can be attained over a wide range, including the central region 13 and the peripheral region 14.

The step of forming the non-power-generating members may further include a step of cutting the submodule structure in a direction intersecting with the main surface 110s after forming the submodule structure through the film formation step and the film processing step. In consequence, the non-power-generating members 60a to 60e of desired sizes can be formed from the submodule structure.

The photovoltaic film may be removed under the same first processing conditions in the film processing step for forming the first submodule 101 and the film processing step for forming the first member 61 adjacent to the first submodule 101 in the third direction (e.g., the X-direction). This allows the photovoltaic layer area ratios of the first member 61 and the first submodule 101 to be equal. The power generation module 2 may further include a second submodule 102 adjacent to the first submodule 101 in the second direction (e.g., the Y-direction). In this case, the photovoltaic film may be removed under second processing conditions different from the first processing conditions in the film processing step for forming the second submodule 102 and the film processing step for forming the second member 62 adjacent to the second submodule 102 in the third direction (e.g., the X-direction). This allows the photovoltaic layer area ratios of the second submodule 102 and the second member 62 to be greater than the photovoltaic layer area ratios of the first submodule 101 and the first member 61. According to the above method, after a common film formation step is performed, by varying the processing conditions in the film processing step, it is possible to separately fabricate submodules and non-power-generating members with different photovoltaic layer area ratios.

The method may include a step of arranging a further filler 31 on the first surface 11s prior to the submodule arrangement step and the non-power-generating member arrangement step. The submodule 100 and the non-power-generating members 60a to 60e are arranged on the further filler 31. By arranging the fillers 31, 32 above and below the non-power-generating members 60a to 60e, the generation of bubbles can be more effectively suppressed.

In plan view along the first direction (Z-direction), adjacent submodules 101 and non-power-generating members (first members 61) may be configured to have the same photovoltaic layer area ratio. This allows the submodules 101 and the first members 61 to have substantially the same light transmittance. This suppresses a significant change in light transmittance at the boundary portion between the central region 13 where power generation occurs and the peripheral region 14, thereby enhancing the design quality.

The power generation module 2 includes, for example, submodules 101, 102 adjacent to each other in a second direction (e.g., Y-direction) in plan view along the first direction (Z-direction). The plural non-power-generating members include the first member 61 adjacent to the submodule 101 in a third direction (X-direction) and the second member 62 adjacent to the submodule 102 in the third direction (X-direction). The photovoltaic layer area ratio of the submodule 101 may be smaller than that of the submodule 102, and the photovoltaic layer area ratio of the first member 61 may be smaller than that of the second member 62. For example, the photovoltaic layer area ratio of the first member 61 may be the same as that of the submodule 101, and the photovoltaic layer area ratio of the second member 62 may be the same as the photovoltaic layer area ratio of the submodule 102.

According to the above configuration, a gradation in which the photovoltaic layer area ratio, and therefore the light transmittance, changes along the second direction (Y-direction) can be formed in the non-power-generating members (the first member 61 and the second member 62) as in the submodules 101, 102. The first member 61 and the second member 62 may each have a string structure similar to that of the submodules 101, 102.

The visible light transmittance of the submodule 101 may be higher than that of the submodule 102, and the visible light transmittance of the first member 61 may be higher than that of the second member 62. The visible light transmittance of the first member 61 and the first submodule 101 may be the same, and the visible light transmittance of the second member 62 and the second submodule 102 may be the same. Alternatively, each of the submodule 101 and the first member 61 may be configured to form a gradation in which the visible light transmittance changes along the second direction (Y-direction). This makes it possible to apply a design (appearance) similar to that of the central region 13 to the peripheral region 14, thereby enhancing the design quality of the power generation module 2.

The power generation module 2 of this embodiment includes the first substrate 11 and the second substrate 12 that have light-transmitting properties, the submodule 100 located between these substrates 11, 12, the non-power-generating members 60a to 60e located between the first substrate 11 and the second substrate 12 and electrically isolated from the submodule 100, the filler 32 located between the submodule 100 and non-power-generating members 60a to 60e and the second substrate 12, and the sealing member 50 located between the first substrate 11 and the second substrate 12. In plan view taken along the first direction (Z-direction), the sealing member 50 is located outside the submodule 100, and the non-power-generating members 60a to 60e are located between the sealing member 50 and the submodule 100. At least a portion of the upper surfaces of the non-power-generating members 60a to 60e is in contact with the filler 32.

In the above configuration, the non-power-generating members 60a to 60e are arranged in the portion between the first substrate 11 and the second substrate 12 where no submodules 100 are arranged. This makes it easier to maintain a constant distance between the first substrate 11 and the second substrate 12. Furthermore, air bubbles are less likely to form inside the sealing member 50 (the portion where the submodule 1100 is not disposed) between the first substrate 11 and the second substrate 12. This provides a power generation module 2 with excellent appearance.

The submodule 100 and the non-power-generating members 60a to 60e each have the base substrate 110, 110d and the photovoltaic layer supported on the main surface of the base substrate 110, 110d.

According to the above configuration, the non-power-generating members 60a to 60e and the submodule 100 have the same structure, so they can be combined to implement an integrated design for the entire window. Furthermore, the light transmittance of the non-power-generating members 60a to 60e and the submodule 100 can be adjusted in the same way (for example, by adjusting the area ratio of the photovoltaic layer).

The submodules 101 and non-power-generating members (first members) 61 may have the same width in a direction orthogonal to the direction of adjacency. This allows the first portions 61 to be arranged in the same column or row as the submodules 101, thereby achieving a unified design between the central region 13 and the peripheral region 14. Alternatively, the width of the first members 61 may be greater than the width of the submodules 101 in the direction orthogonal to the direction of adjacency. For example, the first members 61 may extend adjacent to plural submodules. This reduces the number of boundary portions between adjacent non-power-generating members, further suppressing the impact on the photovoltaic layer caused by air entering gaps at the boundary portions.

«Summary of Embodiments»

<1> A method for manufacturing a power generation module of the present disclosure comprises:

arranging a solar cell submodule on a first surface of a first substrate having light-transmitting properties;
arranging a non-power-generating member electrically isolated from the solar cell submodule in a second region of the first surface, the second region lying outside a first region in which the solar cell submodule is arranged;
placing a filler above the solar cell submodule and the non-power-generating member, the filler being in contact with at least a portion of an upper surface of the non-power-generating member; and
disposing a second substrate having light-transmitting properties on the filler so as to face the first substrate, and bonding together the first substrate and the second substrate with the solar cell submodule and the non-power-generating member between the first and second substrates.

<2> In the method for manufacturing a power generation module according to <1>, wherein

the power generation module further comprises a sealing member disposed in a third region of the first surface, the third region lying outside the second region, and
wherein the method further comprises sealing a space between the first substrate and the second substrate with the sealing member.

<3> In the method for manufacturing a power generation module according to <1> or <2>, wherein
in a first direction in which the first substrate and the second substrate face each other, the non-power-generating member has the same thickness as the solar cell submodule.
<4> In the method for manufacturing a power generation module according to any of <1> to <3>, wherein
in the arranging of the non-power-generating member, a plurality of the non-power-generating members are arranged in the second region without overlapping each other.
<5> In the method for manufacturing a power generation module according to any of <1> to <4>, wherein
the non-power-generating member is formed from the same material as the first substrate or the second substrate.
<6> In the method for manufacturing a power generation module according to any of <1> to <5>, further comprising:

forming the solar cell submodule; and
forming the non-power-generating member, wherein
the forming of the solar cell submodule and the forming of the non-power-generating member each comprises:

forming a laminated film including a photovoltaic film on a main surface of a base substrate having light-transmitting properties; and
processing the laminated film to form a power-generating section including a photovoltaic layer on a part of the main surface,

wherein, in the forming of the laminated film, the photovoltaic film is formed by coating, and
wherein, in the processing of the laminated film, a portion of the photovoltaic film is removed from the main surface by laser processing, and a remaining portion of the photovoltaic film becomes the photovoltaic layer.

<7> In the method for manufacturing a power generation module according to <6>, wherein

the forming of the non-power-generating member further comprises
cutting a submodule structure formed by the forming of the laminated film and the processing of the laminated film in a direction intersecting the main surface, to obtain the non-power-generating member from the submodule structure.

<8> In the method for manufacturing a power generation module according to <6> or <7>, wherein

the arranging of the solar cell submodule includes arranging a plurality of the solar cell submodules including a first submodule in the first region,
the arranging of the non-power-generating member includes arranging a plurality of the non-power-generating members including a first member in the second region without overlapping each other, the first member being adjacent to the first submodule in plan view seen along a first direction in which the first substrate and the second substrate face each other,
wherein, in the processing of the laminated film for forming the first member, the photovoltaic film is removed under first processing conditions the same as those in the processing of the laminated film for forming the first submodule, and
wherein, in plan view seen along the first direction, a photovoltaic layer area ratio of the first member is made equal to a photovoltaic layer area ratio of the first submodule, the photovoltaic layer area ratios of the first submodule and the first member each being defined as a ratio of an area of a portion of its main surface where the photovoltaic layer exists to an area of the main surface.

<9> In the method for manufacturing a power generation module according to <8>, wherein

the plurality of solar cell submodules further include a second submodule adjacent to the first submodule in a second direction, in plan view seen along the first direction,
the plurality of non-power-generating members further include a second member adjacent to the second submodule in a third direction intersecting the second direction, in plan view seen along the first direction, and
wherein, in the processing of the laminated film for forming the second member and the second submodule, the photovoltaic film is removed under second processing conditions different from the first processing conditions, and
wherein, in plan view seen along the first direction, photovoltaic layer area ratios of the second member and the second submodule are made greater than the photovoltaic layer area ratios of the first submodule and the first member.

<10> In the method for manufacturing a power generation module according to any of <6> to <9>, wherein
the photovoltaic layer comprises a perovskite compound.
<11> In the method for manufacturing a power generation module according to any one of <6> to <10>, wherein

the processing of the laminated film in the forming of the solar cell submodule includes forming a plurality of strings each including the photovoltaic layer, each of the plurality of strings being a solar cell element string comprising a plurality of photovoltaic elements connected in series, and
the processing of the laminated film in the forming of the non-power-generating member includes forming a plurality of dummy strings each including the photovoltaic layer, the plurality of dummy strings each having a layered structure similar to that of the strings of the solar cell submodule.

<12> In the method for manufacturing a power generation module according to any one of <1> to <11>, further comprising placing a further filler on the first surface prior to the arranging of the solar cell submodule and the arranging of the non-power-generating member,
wherein the solar cell submodule and the non-power-generating member are arranged on the further filler.
<13> A power generation module of the present disclosure comprises:

a first substrate having light-transmitting properties;
a second substrate having light-transmitting properties and facing the first substrate in a first direction;
a solar cell submodule located between the first substrate and the second substrate;
a non-power-generating member located between the first substrate and the second substrate, the non-power-generating member being electrically isolated from the solar cell submodule; and
a filler located between the solar cell submodule and the second substrate, and between the non-power-generating member and the second substrate,
wherein, in plan view seen along the first direction, the non-power-generating member is adjacent to the solar cell submodule, at least a portion of an upper surface of the non-power-generating member being in contact with the filler.

<14> In the power generation module according to <13>, wherein

the power generation module comprises a sealing member located between the first substrate and the second substrate, and
wherein, in plan view seen along the first direction, the sealing member lies outside the solar cell submodule, and the non-power-generating member lies between the sealing member and the solar cell submodule.

<15> In the power generation module according to <13> or <14>, wherein
the non-power-generating member has the same thickness as the solar cell submodule in the first direction.
<16> In the power generation module according to any one of <13> to <15>, wherein
the non-power-generating member is formed from the same material as the first substrate or the second substrate.
<17> In the power generation module according to any one of <13> to <15>, wherein
the solar cell submodule and the non-power-generating member each comprises:

a base substrate having light-transmitting properties and having a main surface facing the second substrate; and
a photovoltaic layer supported on the main surface of the base substrate.

<18> In the power generation module according to <17> , wherein
the photovoltaic layer of the solar cell submodule and the photovoltaic layer of the non-power-generating member have the same thickness.
<19> In the power generation module according to <17> or <18> , comprising:

a plurality of the solar cell submodules including a first submodule; and
a plurality of the non-power-generating members including a first member, the first member being adjacent to the first submodule in a second direction in plan view seen along the first direction,
wherein, in plan view seen along the first direction, a width of the first member and a width of the first submodule in a direction orthogonal to the second direction are the same.

<20> In the power generation module according to <17> or <18>, comprising:

a plurality of the solar cell submodules including a first submodule; and
a plurality of the non-power-generating members including a first member, the first member being adjacent to the first submodule in a second direction in plan view seen along the first direction,
wherein, in plan view seen along the first direction, a width of the first member is greater than a width of the first submodule in a direction orthogonal to the second direction.

<21> In the power generation module according to <19> or <20>, wherein
a photovoltaic layer area ratio of the first submodule is equal to a photovoltaic layer area ratio of the first member, the photovoltaic layer area ratio being defined as a ratio of an area of a portion where the photovoltaic layer exists to an area of the main surface.
<22> In the power generation module according to <17> or <18>, comprising:

a plurality of the solar cell submodules including a first submodule and a second submodule, the first submodule and the second submodule being adjacent to each other in a second direction in plan view seen along the first direction; and

a plurality of the non-power-generating members including a first member and a second member, the first member being adjacent to the first submodule in a third direction intersecting the second direction and the second member being adjacent to the second submodule in the third direction in plan view seen along the first direction, wherein a photovoltaic layer area ratio of the first submodule is less than a photovoltaic layer area ratio of the second submodule, the photovoltaic layer area ratios of the first submodule and the first member each being defined as a ratio of an area of a portion of its main surface where the photovoltaic layer exists to an area of the main surface, and

wherein the photovoltaic layer area ratios of the first member and the first submodule are the same, and the photovoltaic layer area ratios of the second member and the second submodule are the same.

<23> In the power generation module according to <17> or <18> , comprising:

a plurality of the solar cell submodules including a first submodule and a second submodule, the first submodule and the second submodule being adjacent to each other in a second direction in plan view seen along the first direction; and

a plurality of the non-power-generating members including a first member and a second member, the first member being adjacent to the first submodule in a third direction intersecting the second direction and the second member being adjacent to the second submodule in the third direction in plan view seen along the first direction, wherein a visible light transmittance of the first submodule is higher than a visible light transmittance of the second submodule, and

wherein the visible light transmittances of the first member and the first submodule are the same, and the visible light transmittances of the second member and the second submodule are the same.

<24> In the power generation module according to any one of <19> to <23>, wherein

the solar cell submodule comprises a plurality of strings each including the photovoltaic layer, each of the plurality of strings being a solar cell element string comprising a plurality of photovoltaic elements connected in series, and

the non-power-generating member comprises a plurality of dummy strings each including the photovoltaic layer, the plurality of dummy strings each having a layered structure similar to that of the strings of the solar cell submodule, and

wherein the plurality of strings are arranged at a distance from each other along the second direction, and the plurality of dummy strings are arranged at a distance from each other along the second direction.

<25> In the power generation module according to any one of <17> to <24>, wherein
the photovoltaic layer comprises a perovskite compound.

## INDUSTRIAL APPLICABILITY

The power generation module according to the present disclosure is useful as a power generation module applicable to building-integrated photovoltaic, for example, windows of buildings such as power generating glass.

## REFERENCE SIGNS LIST

| | |
|---|---|
| 1 | power generation module |
| 11 | first substrate |
| 11s | first surface |
| 12 | second substrate |
| 13 | central region (first region) |
| 14 | peripheral region (second region) |
| 15 | sealing region (third region) |
| 21, 22 | lead wire |
| 31 | first filler |
| 32 | second filler |
| 41, 41a to 41c | first wiring |

| 42, 42a to 42c | second wiring |
| 43 | third wiring |
| 50 | sealing member |
| 60a to 60e | non-power-generating member |
| 61 | first member |
| 62 | second member |
| 100 | submodule |
| 101 | first submodule |
| 102 | second submodule |
| 103 | third submodule |
| 104 | fourth submodule |
| 110, 110d | base substrate |
| 110s | main surface of base substrate |
| 120 | string |
| 120d | dummy string |
| 130 | inter-string region |
| 141, 142 | wiring |
| 150 | solar cell element |
| 151 | lower transparent electrode |
| 153 | semiconductor layer |
| 155 | upper transparent electrode |
| 160 | isolation groove |
| 170 | laminated film |
| LB | laser beam |
| LE | lower transparent conductive layer |
| PV | photovoltaic layer |
| UE | upper transparent conductive layer |
| pt, pt1 to pt3 | array pitch |
| R1 to R4 | module row |
| Ra to Rc | module column |
| ws | string width |
| wp | inter-string region width |
| wL, wL1, wL2 | irradiation width |
| wT, wT1, wT2 | non-irradiation width |

**Claims**

1. A method for manufacturing a power generation module, comprising:

   arranging a solar cell submodule on a first surface of a first substrate having light-transmitting properties;
   arranging a non-power-generating member electrically isolated from the solar cell submodule in a second region of the first surface, the second region lying outside a first region in which the solar cell submodule is arranged;
   placing a filler above the solar cell submodule and the non-power-generating member, the filler being in contact with at least a portion of an upper surface of the non-power-generating member; and
   disposing a second substrate having light-transmitting properties on the filler so as to face the first substrate, and bonding together the first substrate and the second substrate with the solar cell submodule and the non-power-generating member between the first and second substrates.

2. The method for manufacturing a power generation module according to claim 1, wherein

   the power generation module further comprises a sealing member disposed in a third region of the first surface, the third region lying outside the second region, and
   wherein the method further comprises sealing a space between the first substrate and the second substrate with the sealing member.

3. The method for manufacturing a power generation module according to claim 1 or 2, wherein
   in a first direction in which the first substrate and the second substrate face each other, the non-power-generating member has the same thickness as the solar cell submodule.

4. The method for manufacturing a power generation module according to claim 1 or 2, wherein
in the arranging of the non-power-generating member, a plurality of the non-power-generating members are arranged in the second region without overlapping each other.

5. The method for manufacturing a power generation module according to claim 1 or 2, wherein
the non-power-generating member is formed from the same material as the first substrate or the second substrate.

6. The method for manufacturing a power generation module according to claim 1 or 2, further comprising:

forming the solar cell submodule; and
forming the non-power-generating member, wherein
the forming of the solar cell submodule and the forming of the non-power-generating member each comprises:

forming a laminated film including a photovoltaic film on a main surface of a base substrate having light-transmitting properties; and
processing the laminated film to form a power-generating section including a photovoltaic layer on a part of the main surface,

wherein, in the forming of the laminated film, the photovoltaic film is formed by coating, and
wherein, in the processing of the laminated film, a portion of the photovoltaic film is removed from the main surface by laser processing, and a remaining portion of the photovoltaic film becomes the photovoltaic layer.

7. The method for manufacturing a power generation module according to claim 6, wherein

the forming of the non-power-generating member further comprises
cutting a submodule structure formed by the forming of the laminated film and the processing of the laminated film in a direction intersecting the main surface, to obtain the non-power-generating member from the submodule structure.

8. The method for manufacturing a power generation module according to claim 6, wherein

the arranging of the solar cell submodule includes arranging a plurality of the solar cell submodules including a first submodule in the first region,
the arranging of the non-power-generating member includes arranging a plurality of the non-power-generating members including a first member in the second region without overlapping each other, the first member being adjacent to the first submodule in plan view seen along a first direction in which the first substrate and the second substrate face each other,
wherein, in the processing of the laminated film for forming the first member, the photovoltaic film is removed under first processing conditions the same as those in the processing of the laminated film for forming the first submodule, and
wherein, in plan view seen along the first direction, a photovoltaic layer area ratio of the first member is made equal to a photovoltaic layer area ratio of the first submodule, the photovoltaic layer area ratios of the first submodule and the first member each being defined as a ratio of an area of a portion of its main surface where the photovoltaic layer exists to an area of the main surface.

9. The method for manufacturing a power generation module according to claim 8, wherein

the plurality of solar cell submodules further include a second submodule adjacent to the first submodule in a second direction, in plan view seen along the first direction,
the plurality of non-power-generating members further include a second member adjacent to the second submodule in a third direction intersecting the second direction, in plan view seen along the first direction, and
wherein, in the processing of the laminated film for forming the second member and the second submodule, the photovoltaic film is removed under second processing conditions different from the first processing conditions, and
wherein, in plan view seen along the first direction, photovoltaic layer area ratios of the second member and the second submodule are made greater than the photovoltaic layer area ratios of the first submodule and the first member.

10. The method for manufacturing a power generation module according to claim 6, wherein
the photovoltaic layer comprises a perovskite compound.

11. The method for manufacturing a power generation module according to claim 6, wherein

the processing of the laminated film in the forming of the solar cell submodule includes forming a plurality of strings each including the photovoltaic layer, each of the plurality of strings being a solar cell element string comprising a plurality of photovoltaic elements connected in series, and
the processing of the laminated film in the forming of the non-power-generating member includes forming a plurality of dummy strings each including the photovoltaic layer, the plurality of dummy strings each having a layered structure similar to that of the strings of the solar cell submodule.

12. The method for manufacturing a power generation module according to claim 1 or 2, further comprising placing a further filler on the first surface prior to the arranging of the solar cell submodule and the arranging of the non-power-generating member,
wherein the solar cell submodule and the non-power-generating member are arranged on the further filler.

13. A power generation module comprising:

a first substrate having light-transmitting properties;
a second substrate having light-transmitting properties and facing the first substrate in a first direction;
a solar cell submodule located between the first substrate and the second substrate;
a non-power-generating member located between the first substrate and the second substrate, the non-power-generating member being electrically isolated from the solar cell submodule; and
a filler located between the solar cell submodule and the second substrate, and between the non-power-generating member and the second substrate,
wherein, in plan view seen along the first direction, the non-power-generating member is adjacent to the solar cell submodule, at least a portion of an upper surface of the non-power-generating member being in contact with the filler.

14. The power generation module according to claim 13, wherein

the power generation module comprises a sealing member located between the first substrate and the second substrate, and
wherein, in plan view seen along the first direction, the sealing member lies outside the solar cell submodule, and the non-power-generating member lies between the sealing member and the solar cell submodule.

15. The power generation module according to claim 13 or 14, wherein
the non-power-generating member has the same thickness as the solar cell submodule in the first direction.

16. The power generation module according to claim 13 or 14, wherein
the non-power-generating member is formed from the same material as the first substrate or the second substrate.

17. The power generation module according to claim 13 or 14, wherein
the solar cell submodule and the non-power-generating member each comprises:

a base substrate having light-transmitting properties and having a main surface facing the second substrate; and
a photovoltaic layer supported on the main surface of the base substrate.

18. The power generation module according to claim 17, wherein
the photovoltaic layer of the solar cell submodule and the photovoltaic layer of the non-power-generating member have the same thickness.

19. The power generation module according to claim 17, comprising:

a plurality of the solar cell submodules including a first submodule; and
a plurality of the non-power-generating members including a first member, the first member being adjacent to the first submodule in a second direction in plan view seen along the first direction,

wherein, in plan view seen along the first direction, a width of the first member and a width of the first submodule in a direction orthogonal to the second direction are the same.

20. The power generation module according to claim 17, comprising:

a plurality of the solar cell submodules including a first submodule; and
a plurality of the non-power-generating members including a first member, the first member being adjacent to the first submodule in a second direction in plan view seen along the first direction,
wherein, in plan view seen along the first direction, a width of the first member is greater than a width of the first submodule in a direction orthogonal to the second direction.

21. The power generation module according to claim 19, wherein
a photovoltaic layer area ratio of the first submodule is equal to a photovoltaic layer area ratio of the first member, the photovoltaic layer area ratio being defined as a ratio of an area of a portion where the photovoltaic layer exists to an area of the main surface.

22. The power generation module according to claim 17, comprising:

a plurality of the solar cell submodules including a first submodule and a second submodule, the first submodule and the second submodule being adjacent to each other in a second direction in plan view seen along the first direction; and
a plurality of the non-power-generating members including a first member and a second member, the first member being adjacent to the first submodule in a third direction intersecting the second direction and the second member being adjacent to the second submodule in the third direction in plan view seen along the first direction,
wherein a photovoltaic layer area ratio of the first submodule is less than a photovoltaic layer area ratio of the second submodule, the photovoltaic layer area ratios of the first submodule and the first member each being defined as a ratio of an area of a portion of its main surface where the photovoltaic layer exists to an area of the main surface, and
wherein the photovoltaic layer area ratios of the first member and the first submodule are the same, and the photovoltaic layer area ratios of the second member and the second submodule are the same.

23. The power generation module according to claim 17, comprising:

a plurality of the solar cell submodules including a first submodule and a second submodule, the first submodule and the second submodule being adjacent to each other in a second direction in plan view seen along the first direction; and
a plurality of the non-power-generating members including a first member and a second member, the first member being adjacent to the first submodule in a third direction intersecting the second direction and the second member being adjacent to the second submodule in the third direction in plan view seen along the first direction,
wherein a visible light transmittance of the first submodule is higher than a visible light transmittance of the second submodule, and
wherein the visible light transmittances of the first member and the first submodule are the same, and the visible light transmittances of the second member and the second submodule are the same.

24. The power generation module according to claim 19, wherein

the solar cell submodule comprises a plurality of strings each including the photovoltaic layer, each of the plurality of strings being a solar cell element string comprising a plurality of photovoltaic elements connected in series, and
the non-power-generating member comprises a plurality of dummy strings each including the photovoltaic layer, the plurality of dummy strings each having a layered structure similar to that of the strings of the solar cell submodule, and
wherein the plurality of strings are arranged at a distance from each other along the second direction, and the plurality of dummy strings are arranged at a distance from each other along the second direction.

25. The power generation module according to claim 17, wherein
the photovoltaic layer comprises a perovskite compound.

Fig. 1

Fig. 2

**Fig. 3**

Fig. 4

Fig. 5

## Fig. 6A

## Fig. 6B

Fig. 7

Fig. 8

Fig. 9A

110s

110

Z
Y
X

Fig. 9B

170

110

110s

Z
Y
X

Fig. 9C

Fig. 9D

# Fig. 9E

# Fig. 9F

Fig. 10A

Fig. 10B

Fig. 10C

Fig. 11

Fig. 12A

Fig. 12B

Fig. 13A

Fig. 13B

Fig. 13C

Fig. 14

POWER-GENERATING
SECTION AREA RATIO (%)
100                0
100

LIGHT
TRANSMITTANCE
(%)

0                   100
PHOTOVOLTAIC FILM REMOVAL
AREA RATIO (%)

Fig. 15

| STEP1 | SET LIGHT TRANSMITTANCE |
|---|---|
| STEP2 | SET TOTAL PHOTOVOLTAIC FILM REMOVAL AREA PER SUBMODULE |
| STEP3 | SET THE NUMBER OF STRINGS |
| STEP4 | SET AREA TO BE REMOVED PER SPOT (SET AREA OF INTER-STRING REGION) |
| STEP5 | SET DATA OF LASER PROCESSING MACHINE |

## Fig. 16

## Fig. 17

Fig. 18

Fig. 19A

Fig. 19B

Fig. 20

Fig. 21

Fig. 22

## Fig. 23

Fig. 24

110s 110

r1

r2

r3

r4

r5

Y

Z⊙ →X

Fig. 25

Fig. 26

Fig. 27

STRING AREA
RATIO

VISIBLE LIGHT
TRANSMITTANCE

90 92 91

FIRST
SUBMODULE

SECOND
SUBMODULE

THIRD
SUBMODULE

DISTANCE ALONG Y-DIRECTION

Fig. 28A

Fig. 28B

Fig. 28C

Fig. 29A

LB

110s

170

110

wL

Z
X → Y

Fig. 29B

130    120    LB    110s

170

110

wT1    wL

Z
X → Y

Fig. 29C

130    120    LB    110s

170

110

wT2    wL    (wT2>wT1)

Z
X → Y

Fig. 30

Fig. 31

## Fig. 32A

## Fig. 32B

Fig. 33

Fig. 34

Fig. 35A

100    31    11s

Z
↑
Y⊗→X

13    14    15    11

Fig. 35B

100  60b  31    11s

Z
↑
Y⊗→X

13    14    15    11

Fig. 35C

100    60b    32    12

31
11s
11

Z
↑
Y⊗→X

13    14    15

Fig. 35D

100    60b    32    12

50
31
11

Z
↑
Y⊗→X

13    14    15

Fig. 36A

Fig. 36B

Fig. 36C

Fig. 36D

## INTERNATIONAL SEARCH REPORT

| International application No. |
|---|
| **PCT/JP2024/025581** |

| A. | CLASSIFICATION OF SUBJECT MATTER |
|---|---|

*H10K 39/10*(2023.01)i; *H10K 30/40*(2023.01)i
FI:   H10K39/10; H10K30/40

According to International Patent Classification (IPC) or to both national classification and IPC

| B. | FIELDS SEARCHED |
|---|---|

Minimum documentation searched (classification system followed by classification symbols)

H01L31/00-31/078; H01L31/18-31/20; H10K39/00-99/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2018-26439 A (MITSUBISHI CHEMICAL CORPORATION) 15 February 2018 (2018-02-15) <br> paragraphs [0012], [0020]-[0021], [0029], [0037], [0045]-[0046], [0057]-[0058], [0066], [0069], [0089]-[0099], [0102], fig. 1-4 | 1-4, 6-8, 11, 13-15, 17-21, 24 |
| Y | | 10, 12, 25 |
| A | | 5, 9, 16, 22-23 |
| Y | JP 2017-135377 A (MITSUBISHI CHEMICAL CORPORATION) 03 August 2017 (2017-08-03) <br> paragraph [0074], fig. 1-2 | 10, 12, 25 |
| A | JP 2005-317665 A (NAKAJIMA GLASS CO., INC.) 10 November 2005 (2005-11-10) <br> entire text, all drawings | 1-25 |
| A | JP 2012-164960 A (LG ELECTRONICS INC.) 30 August 2012 (2012-08-30) <br> entire text, all drawings | 1-25 |

☑ Further documents are listed in the continuation of Box C.     ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 August 2024** | **03 September 2024** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

## INTERNATIONAL SEARCH REPORT

International application No.

**PCT/JP2024/025581**

### C. DOCUMENTS CONSIDERED TO BE RELEVANT

| Category* | Citation of document, with indication, where appropriate, of the relevant passages | Relevant to claim No. |
|---|---|---|
| A | JP 2012-89403 A (SONY CORPORATION) 10 May 2012 (2012-05-10)<br>entire text, all drawings | 1-25 |
| A | US 2014/0238472 A1 (LG INNOTEK CO., LTD.) 28 August 2014 (2014-08-28)<br>entire text, all drawings | 1-25 |

Form PCT/ISA/210 (second sheet) (July 2022)

**INTERNATIONAL SEARCH REPORT**
Information on patent family members

International application No.

**PCT/JP2024/025581**

| Patent document cited in search report | | | Publication date (day/month/year) | Patent family member(s) | | | Publication date (day/month/year) |
|---|---|---|---|---|---|---|---|
| JP | 2018-26439 | A | 15 February 2018 | (Family: none) | | | |
| JP | 2017-135377 | A | 03 August 2017 | (Family: none) | | | |
| JP | 2005-317665 | A | 10 November 2005 | (Family: none) | | | |
| JP | 2012-164960 | A | 30 August 2012 | US entire text, all drawings KR | 2011/0265848 10-2012-0090250 | A1 A | |
| JP | 2012-89403 | A | 10 May 2012 | (Family: none) | | | |
| US | 2014/0238472 | A1 | 28 August 2014 | KR CN | 10-2013-0042204 104025308 | A A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020084640 A

- JP 10299353 A